(19) Europäisches Patentamt
European Patent Office
Office européen des brevets

(11) **EP 3 350 116 B1**

(12) # FASCICULE DE BREVET EUROPEEN

(45) Date de publication et mention de la délivrance du brevet:
**10.08.2022 Bulletin 2022/32**

(21) Numéro de dépôt: **16775495.1**

(22) Date de dépôt: **15.09.2016**

(51) Classification Internationale des Brevets (IPC):
***B82Y 10/00*** *(2011.01)* ***B82Y 40/00*** *(2011.01)*
***G03F 7/00*** *(2006.01)*

(52) Classification Coopérative des Brevets (CPC):
**G03F 7/0002; B82Y 10/00; G06N 5/003;**
B82Y 40/00

(86) Numéro de dépôt international:
**PCT/EP2016/071907**

(87) Numéro de publication internationale:
**WO 2017/046287 (23.03.2017 Gazette 2017/12)**

(54) **MOULE DE LITHOGRAPHIE POUR IMPRESSION NANOMÉTRIQUE ET PROCÉDÉS DE FABRICATION ET D'UTILISATION D'UN TEL MOULE**

LITHOGRAPHIEFORM FÜR NANOMETRISCHEN ABDRUCK UND VERFAHREN ZUR HERSTELLUNG UND VERWENDUNG SOLCH EINER FORM

LITHOGRAPHY MOULD FOR NANOMETRIC IMPRESSION AND METHODS FOR MANUFACTURING AND USING SUCH A MOULD

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **15.09.2015 FR 1558623**

(43) Date de publication de la demande:
**25.07.2018 Bulletin 2018/30**

(73) Titulaire: **Commissariat à l'Énergie Atomique et aux Énergies Alternatives**
**75015 Paris (FR)**

(72) Inventeurs:
- **CONSTANCIAS, Christophe**
  **38700 Sarcenas (FR)**
- **LANDIS, Stéphan**
  **38210 Tullins (FR)**

(74) Mandataire: **Hautier IP**
**20, rue de la Libérté**
**06000 Nice (FR)**

(56) Documents cités:
**EP-A1- 2 483 744** **US-A1- 2012 086 149**

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).

EP 3 350 116 B1

## Description

### DOMAINE TECHNIQUE DE L'INVENTION

La présente invention concerne en général la lithographie et plus particulièrement la lithographie par impression nanométrique.

### ÉTAT DE LA TECHNIQUE

Parmi les techniques de lithographie mises en oeuvre par l'industrie de la microélectronique pour la production de circuits intégrés et, plus généralement, de circuits pouvant combiner composants électroniques, optiques et mécaniques, la technique d'impression nanométrique suscite un intérêt croissant.

Cette technique repose sur l'impression avec un moule d'une résine déformable. Le moule comporte des motifs qui sont transférés dans la résine lors de l'impression et qui se mesurent couramment en dizaines de nanomètres.

Dans ce domaine les techniques standards de nano impression font actuellement usage de deux types de moules : des moules dits « rigides » et des moules dits « souples ». Le principal avantage des moules rigides est qu'il est alors possible d'utiliser pour leur fabrication les mêmes procédés standards que ceux mis en œuvre pour les micro et nanotechnologies et qui permettent de réaliser des motifs d'une résolution très élevée, jusqu'à quelques nanomètres, et avec de très bons états de surface, c'est-à-dire, au regard des standards de l'industrie de la micro-électronique, une défectivité qui n'excède pas $10^{-2}$ défauts par $cm^2$. Ces moules sont ainsi facilement manipulables du fait de leur rigidité intrinsèque. Leur durée de vie est supérieure aux moules souples car on emploie pour leur fabrication des matériaux durs, à base de minéraux, ce qui n'entraine pas de dégradation chimique ou physique significative lors d'une utilisation normale de ceux-ci.

Toutefois, le principal inconvénient résultant de l'utilisation de matériaux durs et de masques rigides est qu'il devient alors très difficile, voire impossible, d'imprimer sur la totalité de la surface d'un substrat ou « wafer » les motifs à reproduire dans la résine avec une très bonne homogénéité, c'est-à-dire avec une distribution d'épaisseur résiduelle uniforme sur toute la surface imprimée. L'épaisseur résiduelle est l'épaisseur restante comprimée par les motifs en saillie du moule, épaisseur qui idéalement doit être la même sur la totalité de la surface après impression de la résine. Ceci se manifeste plus particulièrement avec la technologie dite « UV-Imprint » où l'on utilise des moules transparents en quartz qui sont extrêmement rigides, le durcissement de la résine après impression étant alors obtenu par exposition à un rayonnement ultra-violet (UV) à travers le moule transparent qui reste en place pendant cette opération.

Un autre inconvénient des moules rigides est leur fragilité qui se manifeste, par exemple, quand une poussière se retrouve accidentellement sur la surface de résine à imprimer. Comme la pression appliquée est grande afin d'obtenir un pressage conforme et que leur capacité de déformation est très limitée, le risque de casse est alors élevé.

En ce qui concerne les moules souples, leur avantage principal est la capacité qu'ils procurent de pouvoir réaliser un contact conforme sur toute la surface à imprimer ce qui permet d'optimiser l'uniformité de pressage et ainsi d'obtenir une distribution plus homogène de l'épaisseur résiduelle mentionnée ci-dessus. En outre, leur souplesse permet de réduire les risques de casse en présence de poussières entre la surface à imprimer et le moule. Un autre avantage est qu'ils sont réalisés avec des matériaux organiques à partir d'un moule-mère ou « master ». Les copies à partir du moule-mère sont alors moins coûteuses à fabriquer tout en préservant l'original qui ne sera utilisé que pour faire d'autres copies.

Parmi les inconvénients on notera que leur durée de vie est généralement plus faible que les moules rigides car les matériaux organiques utilisés pour leur fabrication se détériorent au fil de l'utilisation du moule.

Par ailleurs, il est très difficile d'atteindre des résolutions comparables à celles des moules rigides car la tenue mécanique des moules souples est moins bonne. Aussi, les procédures d'alignement s'avèrent être plus compliquées à mettre en oeuvre car la souplesse du moule entraine des déformations des motifs à imprimer pendant l'étape de pressage qui peuvent être difficiles à compenser. Cet inconvénient est d'autant plus important que la surface des moules est grande alors même que les moules souples sont généralement préférés pour imprimer de grandes surfaces.

Les documents EP2483744 A1 et US 2012/086149 A1 sont documents de l'art antérieur pertinents.

Il existe donc un besoin consistant à proposer une solution pour réduire voire pour supprimer certains au moins des inconvénients des solutions mentionnées ci-dessus.

Les autres objets, caractéristiques et avantages de la présente invention apparaîtront à l'examen de la description suivante et des dessins d'accompagnement. Il est entendu que d'autres avantages peuvent être incorporés.

### RÉSUMÉ DE L'INVENTION

L'invention est définie par le jeu de revendications ci-joint. En particulier un moule de lithographie pour impression nanométrique, comprenant une face avant présentant au moins un motif destiné à être transféré par pressage dans une couche imprimable, caractérisé en ce qu'il comprend :

au moins une membrane flexible en matériau inorganique formant ladite face avant et portant l'au moins un motif, la membrane présentant également une face arrière opposée à ladite face avant;
un cadre solidaire d'une périphérie de la membrane et configuré pour former avec ladite face arrière au moins une cavité;
le moule étant configuré de manière à ce qu'une mise sous pression de l'au moins une cavité provoque une déformation de la membrane générant un déplacement de l'au moins un motif dans un sens d'impression éloignant l'au moins un motif du cadre, ladite au moins une membrane étant en tension de sorte que son fléchissement f sous l'effet de son propre poids soit inférieure à une tolérance d'alignement prédéterminée de l'au moins un motif (120), la tolérance d'alignement étant inférieure ou égale à 20nm (10-9 mètres);

Ainsi, en utilisant la flexibilité de la membrane, une mise sous pression de la cavité permet de faire respectivement avancer ou reculer les motifs, afin de procéder aux étapes de pénétration et respectivement de retrait des motifs hors de la couche imprimable.
Plusieurs avantages significatifs découlent du procédé selon l'invention.
Le moulage et le démoulage s'effectuant par pelage sont ainsi automatiques en contrôlant la pression dans la cavité.
La zone supportant les motifs étant souple, l'impression est plus homogène et le contact quasi conforme entre le moule et la résine à imprimer. Cela permet de limiter les défauts et l'impact d'éventuelles poussières qui pourraient conduire à la détérioration d'un moule rigide.
Par ailleurs, la membrane peut être suffisamment fine pour être transparente, permettant de ce fait de supporter des marques d'alignement qui pourront servir à aligner la couche imprimable à imprimer avec les motifs du moule.
En outre, par rapport à une solution basée sur un moule souple, l'utilisation du cadre rigide du moule selon l'invention permet de limiter les déformations pendant la phase d'alignement et de pressage. On obtient donc une précision et une homogénéité améliorées des motifs.
La membrane est composée d'un ou plusieurs matériau(s) inorganiques c'est-à-dire de matériaux minéraux ou métalliques et notamment, de semi-conducteurs tel que du silicium, des isolants tels que des oxydes ou des nitrures et notamment de l'oxyde de silicium ou du nitrure de silicium, des métaux comme l'aluminium etc.
Par membrane flexible, on entend une membrane apte à se déformer de manière élastique avec une flèche supérieure à l'épaisseur de cette membrane. A l'opposé le cadre est rigide avec une aptitude à se déformer bien inférieure. La flexibilité de la membrane est obtenue principalement par sa faible épaisseur. On a ainsi un ratio supérieur à 20 voire à 50 et même 100 entre l'épaisseur de la membrane (typiquement de l'ordre du micron) et l'épaisseur du cadre (typiquement de l'ordre de l'épaisseur d'une tranche de silicium soit de l'ordre de 500 ou 750 microns).
De manière facultative, le moule peut en outre présenter au moins l'une quelconque des caractéristiques facultatives suivantes prises séparément ou en combinaison :
Selon l'invention telle que définie par les revendications l'au moins une membrane est en tension de sorte que son fléchissement f sous l'effet de son propre poids soit inférieure à une tolérance d'alignement prédéterminée des motifs.
Selon l'invention telle que définie par les revendications la tolérance d'alignement est inférieure ou égale à 20 nm ($10^{-9}$ mètres), de préférence inférieure ou égale à 15 nm, inférieure ou égale à 5 nm.
Selon un mode de réalisation le moule est configuré de manière à ce qu'un relâchement de la pression dans l'au moins une cavité ou une mise en dépression de l'au moins une cavité provoque une déformation de la membrane générant un déplacement du motif dans un sens de démoulage les rapprochant du cadre.
Selon un mode de réalisation la solidarisation entre le cadre et la périphérie de la membrane flexible forme un pourtour fermé et continu. Ainsi toute la périphérie de la membrane flexible est solidaire du cadre.
Selon un mode de réalisation les motifs sont en saillie sur la face avant.
Selon un mode de réalisation la couche imprimable est une couche de résine.
Selon un mode de réalisation la membrane et le cadre sont formés dans deux couches superposées.
Selon un mode de réalisation la membrane flexible présente une transparence d'au moins 20% à un rayonnement lumineux contenue dans une gamme de longueur d'ondes comprise entre 380 et 780 nanomètres, longueurs d'ondes visibles.
Selon un mode de réalisation le moule comprend au moins une butée de positionnement du moule par rapport à la couche imprimable, l'au moins une butée de positionnement s'étendant au-delà de la face avant de la membrane flexible, hors d'une zone comprenant l'au moins un motif et sur une hauteur supérieure à la hauteur de l'au moins un motif, les hauteurs étant mesurées dans une direction perpendiculaire à un plan dans lequel s'étend principalement le cadre. Ce plan est le plan dans lequel s'étend principalement la membrane en l'absence de pression dans la cavité.
Ainsi les butées opèrent dans la direction d'impression afin de faciliter la mise et le maintien en position du moule par rapport à la couche imprimable. Elles permettent ainsi de contrôler la profondeur et l'épaisseur résiduelle d’impression.

Selon un mode de réalisation l’au moins une butée de positionnement s’étend au-delà de la face avant de la membrane flexible et est située dans l’alignement du cadre perpendiculairement à un plan dans lequel s’étend principalement le cadre.

Les butées sont donc maintenues par le cadre et non pas par les membranes flexibles. Cela permet de renforcer la tenue du moule.

Ainsi l’au moins une butée de positionnement n’est pas située dans l’alignement des cavités perpendiculairement à un plan dans lequel s’étend principalement le cadre.

Ainsi l’au moins une butée de positionnement n’est pas située sur la membrane flexible.

Selon un mode de réalisation le moule comprend une pluralité de butées de positionnement.

Selon un mode de réalisation l’au moins une butée de positionnement est configurée de manière à ce que sa hauteur hc détermine le fléchissement f maximal de l’au moins une membrane lors de la mise sous pression de l’au moins une cavité et lorsque l’au moins une butée de positionnement prend appui sur la couche imprimable. Ladite hauteur hc est configurée de sorte que le fléchissement f de l’au moins une membrane lors de la mise sous pression de l’au moins une cavité soit inférieure à ladite tolérance d’alignement des motifs.

Selon un mode de réalisation une pluralité de butées de positionnement est associée à une même membrane, ladite pluralité de butées de positionnement étant de préférence réparties sur un pourtour de l’au moins une membrane. Par exemple, pour une membrane carrée ou polygonale, on prévoit quatre plots, disposés à chaque coin ou sur un côté de la membrane.

Selon un mode de réalisation l’au moins une butée de positionnement forme un encadrement autour d’une même membrane, ledit encadrement étant de préférence ajouré pour permettre un passage de gaz lors du déplacement de la membrane. Selon un mode de réalisation ledit encadrement est conformé pour délimiter, avec la face avant de la membrane, une pluralité de cavités avant destinées à être placées en regard de la couche à imprimer.

Il se comprend de manière évidente dans la suite de la description que la hauteur de ces butées est une caractéristique particulièrement avantageuse pour obtenir de manière simple et reproductible une très bonne précision. En effet les butées déterminent la hauteur maximale jusqu’à laquelle la membrane peut parvenir lorsqu’elle se déforme sous l’effet de la pression qui lui est appliquée en face arrière. Ainsi une fois la butée appliquée sur la couche imprimable, sa hauteur conditionne la déformation maximale de la membrane lorsqu’elle pénètre dans la couche déformable. En contrôlant la hauteur de la butée on limite ainsi efficacement et simplement sa déformation lors de la mise sous pression de la membrane. Les butées facilitent donc la mise en oeuvre de l’invention puisqu’il suffit de venir mettre les butées au contact de la surface imprimable pour contrôler la déformation maximale de la membrane et au final améliorer la précision des motifs obtenus.

Cette caractéristique avantageuse de la présente invention ressortira plus en détail dans la description détaillée de l’invention.

Avantageusement si on a une pluralité de membranes, chaque membrane peut être pourvue de ces propres butées ce qui permettra en plus des avantages mentionnés ci-dessus, de compenser une certaine variation de planéité à l’échelle du substrat, du moule et ou de la surface à imprimer.

Selon une alternative, le moule ne comprend pas de butées. Dans ce cas, il faut contrôler précisément la distance entre la membrane par exemple au repos et la surface à imprimer.

Selon un mode de réalisation l’au moins une membrane, le cadre et l’au moins une butée positionnement sont obtenus à partir de couches différentes formant une partie au moins d’un empilement de couches.

Selon un mode de réalisation le cadre forme une grille conformée pour délimiter une pluralité de cavités.

Selon un mode de réalisation chaque cavité est associée à une membrane. Le cadre délimite entièrement la périphérie de la membrane flexible de chaque cavité.

Ce mode de réalisation est particulièrement avantageux lorsque les zones imprimées sont divisées en puces de surface plus petites que la surface totale du moule. Le cadre permet de rigidifier l’intégralité du moule et confère donc une meilleure précision d’alignement à l’échelle du substrat (wafer). Comme les différentes zones à imprimer, c’est à dire les informations contenues sur la zone souple du moule, seront indépendantes les unes des autres, les dernières erreurs d’alignement et de déformation seront sur la plaque plus homogènes d’une puce à l’autre. Dans le mode de réalisation où tout le moule est souple, les erreurs se propagent de proche en proche sur toute la surface à imprimer, induisant une baisse d’homogénéité à l’échelle du wafer.

Comme il est clairement indiqué dans la suite de la description, la surface à imprimer est une surface « plane » c’est-à-dire typiquement avec une flèche inférieure au millimètre pour un substrat dont la dimension maximale est d’environ 300 mm, la dimension maximale du substrat étant son diamètre s’il est circulaire ou son plus grand côté s’il est polygonal. Dans la présente description, une surface plane peut également se comprendre d’une surface dont le rayon de courbure est supérieur à 30 mètres, de préférence supérieur à 50 mètres, et de préférence supérieur à 100 mètres.

La surface à imprimer peut par ailleurs présenter une certaine topologie de surface due à la présence de tout ou partie de composants notamment de l'ordre de 10 nm à quelques micromètres.

Selon un mode de réalisation le moule comprend pour chacune des cavités au moins une butée de positionnement du moule par rapport à la couche imprimable, l'au moins une butée de positionnement s'étendant au-delà de la face avant de la membrane flexible et hors de zones comprenant l'au moins un motif.

Selon un mode de réalisation la membrane flexible de chaque cavité porte l'ensemble des motifs destinés à l'impression d'une unique puce. Cette unique puce est fabriquée simultanément avec un ensemble d'autres puces au cours d'une série d'étapes communes sur un substrat du type de ceux utilisés par l'industrie de la micro-électronique.

La relation générale entre le fléchissement f et la surface de la membrane est donnée par cette expression où $a^2$ correspond à la surface pour une membrane carrée de largeur a :

$$P = \frac{E}{1-\nu}\frac{e^3 f}{a^4}\left[\frac{1}{12\alpha(1+\nu)} + C\frac{f^2}{e^2}\right] + C^*\sigma_0\frac{ef}{a^2}$$

où P est la pression appliquée sur la membrane (ici P=0), E et v respectivement le module d'élasticité et le coefficient de Poisson du matériau constitutif de la membrane, e l'épaisseur de la membrane, C, C* et $\alpha$ des constantes géométriques et $\sigma_0$ la contrainte appliquée à la membrane. On peut grâce à cette formule déterminer le dimensionnement de la membrane. Ce qu'il faut c'est que l'allongement de la membrane sous son propre poids (à l'exclusion d'une pression extérieure) soit inférieur à la tolérance de l'alignement recherché qui est par exemple de l'ordre de 5nm. Si cela n'est pas respecté, il faut redimensionner la membrane ou la tendre (en utilisant par exemple un matériau contraint) pour que ce critère soit respecté.

L'utilisation d'une membrane sous contrainte, avantageusement maintenue sous contrainte par le cadre 130, permet ainsi de compenser le fléchissement de sa surface dû à son propre poids et apporte un degrés de liberté supplémentaire dans le contrôle du fléchissement de la membrane 110, que cela soit en position de repos ou bien lorsqu'une pression lui est appliquée.

Ainsi, en fonction de la contrainte en tension on limite le fléchissement de la membrane sous son propre poids.

Selon un mode de réalisation l'au moins une membrane est, en l'absence de pression dans la cavité, maintenue en tension par le cadre depuis sa périphérie de manière à ce que le fléchissement f de l'au moins une membrane sous son propre poids reste inférieure à ladite tolérance d'alignement des motifs. Selon un mode de réalisation la tension maintenue par le cadre est inférieure ou égale à 100 mPa ($10^6$ Pascal) pour une membrane en silicium présentant une dimension maximale qui est inférieure ou égale à 30 mm, la dimension maximale étant un côté d'une membrane polygonale ou un diamètre d'une membrane circulaire pour 3 $\mu$m ($10^{-6}$ mètres) d'épaisseur.

De manière avantageuse, et à titre non limitatif, la membrane a typiquement sa plus grande longueur (son diamètre ou son plus grand côté) inférieure ou égale à 35 mm et une épaisseur inférieure ou égale à 3 micromètres.

Selon un mode de réalisation la surface de la membrane flexible est plus grande que celle strictement nécessaire pour accueillir l'ensemble des motifs en saillie à imprimer dans la couche imprimable, d'une valeur qui est estimée après calcul d'une surface effective d'impression dépendant de la déformation qu'il faut appliquer à la membrane flexible, par mise sous pression de celle-ci, afin d'atteindre la profondeur d'impression souhaitée dans la couche imprimable.

Selon un mode de réalisation le cadre comprend une face avant au regard de la face arrière de l'au moins une membrane et une face arrière opposée à sa face avant et le moule comprend un support solidaire de sa face arrière et configuré pour fermer l'au moins une cavité.

Avantageusement, le support renforce la rigidité du moule.

Avantageusement, le support est configuré pour permettre de manipuler le moule afin de pouvoir le positionner dans toutes les directions.

Selon un mode de réalisation le support est rigide.

Selon un mode de réalisation le support est au moins en partie et de préférence entièrement transparent.

Selon un mode de réalisation le cadre forme une grille conformée pour délimiter une pluralité de cavités et le support présente pour chaque cavité au moins une ouverture conformée pour sélectivement autoriser une injection dans ou un retrait hors de la cavité un gaz afin de réguler la pression dans la cavité.

Selon un mode de réalisation le cadre forme une grille conformée pour délimiter une pluralité de cavités, le cadre comporte des canaux de communication inter cavités conformés pour mettre à la même pression au moins un ensemble de cavités prises parmi ladite pluralité de cavités. Le support comporte au moins une ouverture conformée pour sélectivement injecter dans ou retirer d'au moins une cavité dudit ensemble de cavités un gaz afin de réguler la pression dans la cavité.

Ainsi il peut y avoir moins d'ouvertures qu'il n'y a de membranes et de cavités. En revanche, il y a autant de canaux de communication inter cavités que nécessaire pour pouvoir mettre toutes les membranes en pression et en dépression.

Cela permet de simplifier la connexion fluidique entre le moule et la source de pression.

Selon un mode de réalisation la membrane est formée à base de ou par l'un des matériaux suivants : silicium monocristallin, en silicium poly cristallin, en silicium amorphe, nitrure de silicium ($Si_3N_4$), silice ($SiO_2$).

Un autre aspect de la présente invention concerne un système comprenant un moule selon l'invention et un dispositif d'injection d'un fluide, typiquement un gaz dans ladite au moins une cavité.

Selon un mode de réalisation ce dispositif comprend au moins un conduit d'amenée et de retrait du gaz dans et hors de la cavité, ainsi qu'une source de gaz configurée pour injecter le gaz sous pression dans la cavité.

Un autre aspect de la présente invention concerne un procédé de lithographie pour impression nanométrique utilisant un moule selon l'invention ou un système selon l'invention, le procédé comprenant les étapes suivantes:

positionner la face avant du moule parallèlement à la couche imprimable ;

mettre sous pression l'au moins une cavité pour provoquer une déformation de la membrane flexible de manière à générer un déplacement de l'au moins un motif en direction de la couche imprimable et la pénétration de l'au moins un motif dans la couche imprimable jusqu'à une profondeur prédéterminée ;

mettre en dépression ladite cavité ou baisser la pression dans ladite cavité pour permettre un retour élastique de la membrane flexible de manière à générer un retrait complet de l'au moins un motif hors de la couche imprimable.

De manière facultative, le procédé d'utilisation du moule peut en outre présenter au moins l'une quelconque des caractéristiques facultatives suivantes prises séparément ou en combinaison :
Selon un mode de réalisation le procédé comprend, avant le déplacement de l'au moins un motif en direction de la couche imprimable, une étape de mise en position du moule par rapport à la couche imprimable ou à un substrat solidaire de la couche imprimable, l'étape de mise en position comprenant une étape d'alignement du moule sur des marques ou des motifs d'alignement préalablement réalisés à la surface de la couche imprimable ou du substrat solidaire de la couche imprimable.

Selon un mode de réalisation la membrane est transparente et les marques ou les motifs d'alignement sont situés au regard de la membrane transparente au moins lorsque l'étape de positionnement est achevée.

Selon un mode de réalisation le moule comprend au moins une butée de positionnement dont la hauteur est supérieure à celle de l'au moins un motif et le procédé comprend, avant le déplacement de l'au moins un motif en direction de la couche imprimable, une étape de mise en position du moule par rapport à la couche imprimable ou à un substrat solidaire de la couche imprimable, l'étape de mise en position comprenant une étape de rapprochement relatif du moule et de la couche imprimable jusqu'à ce que l'au moins une butée de positionnement entre au contact de la couche imprimable ou du substrat solidaire de la couche imprimable.

Selon un mode de réalisation chaque cavité présente une ouverture ou un canal de communication permettant une communication fluidique directe ou indirecte entre la cavité et une source de pression/dépression. La mise sous pression de la cavité comprend l'injection d'un gaz dans la cavité et la mise en dépression de ladite cavité comprend le retrait du gaz hors de la cavité.

Selon un mode de réalisation le procédé comprend après pénétration de l'au moins un motif dans la couche imprimable et avant retrait de l'au moins un motif hors de la couche imprimable, une étape de durcissement de la couche imprimable.

Selon un mode de réalisation l'étape de durcissement de la couche imprimable comprend une exposition de la couche imprimable à un rayonnement de préférence ultra-violet.

Selon un mode de réalisation le moule est au moins en partie transparent audit rayonnement et l'exposition est effectuée à travers ledit moule.

Selon un mode de réalisation le durcissement de la couche imprimable est obtenu thermiquement.

Un autre aspect de la présente invention concerne un procédé de fabrication d'un moule de lithographie pour impression nanométrique comprenant les étapes suivantes effectuées à partir d'un substrat :

Former sur une face avant du substrat au moins un motif destiné à être transféré par pressage dans une couche imprimable;
Amincir au moins une zone d'une face arrière du substrat jusqu'à obtenir pour chaque zone une membrane flexible dont la périphérie est solidaire d'une partie du substrat présentant une épaisseur plus importante et formant un cadre, la membrane et le cadre définissant une cavité;

les étapes de formation de l'au moins un motif et d'amincissement étant réalisées de manière à ce que la membrane flexible porte l'au moins un motif.

Ce procédé est particulièrement fiable et simple pour obtenir un moule selon l'invention.

De manière facultative, le procédé de fabrication du moule peut en outre présenter au moins l'une quelconque des caractéristiques facultatives suivantes prises séparément ou en combinaison :
Selon un mode de réalisation l'étape de formation de l'au moins un motif est réalisée avant l'étape d'amincissement. Alternativement l'étape de formation de l'au moins un motif est réalisée après l'étape d'amincissement.

Selon un mode de réalisation l'étape de formation de l'au moins un motif comprend une étape de réalisation de l'au moins un motif par photolithographie ou par lithographie par faisceau d'électrons, par lithographie extrême ultraviolet (EUV).

Selon un mode de réalisation le procédé comprend une étape de formation d'au moins une butée de positionnement à partir de la face avant du substrat.

Selon un mode de réalisation l'étape de formation de l'au moins une butée de positionnement est réalisée avant l'étape d'amincissement. Alternativement l'étape de formation de l'au moins une butée de positionnement est réalisée après l'étape d'amincissement.

Selon un mode de réalisation le substrat est un empilement de couches, le cadre rigide étant formé dans au moins une première couche et la membrane étant formée dans au moins une deuxième couche recouvrant directement ou non la première couche, les premières et deuxième couches étant distinctes.

Selon un mode de réalisation au cours de l'étape d'amincissement on grave la première couche pour former la cavité jusqu'à parvenir sur ou dans la deuxième couche.

Selon un mode de réalisation la deuxième couche est contrainte en tension au sein de l'empilement de couches.

Selon un mode de réalisation le substrat est un empilement de couches de type silicium sur isolant (SOI).

## BRÈVE DESCRIPTION DES FIGURES

Les buts, objets, ainsi que les caractéristiques et avantages de l'invention ressortiront mieux de la description détaillée de modes de réalisation de cette dernière qui sont illustrés par les dessins d'accompagnement suivants dans lesquels :

La FIGURE 1, composée des figures 1a à 1e, décrit la structure d'un moule de nano impression selon un exemple de réalisation de l'invention ainsi qu'un exemple de procédé d'utilisation d'une tel moule.
La FIGURE 2, composée des figures 2a à 2c, compare un moule selon l'état de la technique (figure 2a) à deux types de moule selon l'invention (figures 2b et 2c).
La FIGURE 3, composée des figures 3a et 3b, compare la transmission de lumière à travers les membranes flexibles d'un moule selon l'invention en fonction des matériaux utilisés et de l'épaisseur des membranes.
La FIGURE 4 décrit un modèle utilisable pour déterminer l'allongement $\Delta L$ d'une membrane flexible d'un moule selon l'invention en fonction de la déformation f de celle-ci.
La FIGURE 5, composée des figures 5a à 5c, décrit un autre modèle permettant de calculer la déformation d'une membrane flexible et étudie la contrainte en tension qu'il faut appliquer à la membrane pour limiter sa déformation.
La FIGURE 6, composée des figures 6a et 6b, montre comment déterminer la surface d'impression effective d'une membrane flexible d'un moule selon l'invention.
La FIGURE 7, composée des figures 7a à 7d, décrit un autre mode de réalisation de l'invention dans lequel on réalise des butées permettant de contrôler la distance à respecter entre le moule et une couche de résine avant impression de cette dernière. La FIGURE 8 illustre un autre mode de réalisation de l'invention dans lequel on utilise un support rigide transparent en face arrière de la membrane pour maintenir le moule et pouvoir ainsi contrôler son déplacement.
La FIGURE 9 composée des figures 9a et 9b décrit un autre mode de réalisation de l'invention dans lequel on pratique moins d'ouvertures dans le support rigide transparent qu'il n'y a de membranes d'impression.
La FIGURE 10 résume les différentes étapes d'un exemple de procédé de conception d'un moule selon l'invention en fonction de son application.
La FIGURE 11, composée des figures 11a à 11c, illustre un mode de réalisation d'un moule selon l'invention en partant d'un substrat SOI.
La FIGURE 12, composée des figures 12a à 12c, illustre un autre mode de réalisation d'un moule selon l'invention où les cavités sont tout d'abord réalisées dans un substrat homogène.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier les épaisseurs relatives des différentes couches, motifs, butées et autres structures ne sont pas représentatives de la réalité.

DESCRIPTION DÉTAILLÉE DE L'INVENTION

Il est précisé que dans le cadre de la présente invention, le terme « sur », « surmonte », « recouvre » ou « sous-jacent » ou leurs équivalents ne signifient pas « au contact de ». Ainsi par exemple, le dépôt d'une première couche sur une deuxième couche, ne signifie pas obligatoirement que les deux couches sont directement au contact l'une de l'autre mais cela signifie que la première couche recouvre au moins partiellement la deuxième couche en étant soit directement à son contact soit en étant séparée d'elle par au moins une autre couche ou au moins un autre élément.

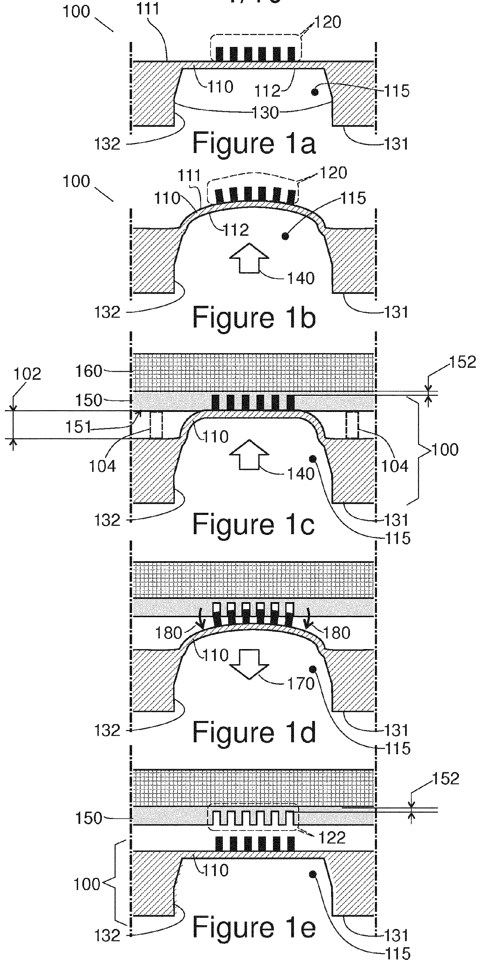

La **figure 1** composée des figures 1a à 1e décrit la structure d'un moule 100 de nano impression selon l'invention et son mode d'utilisation pour obtenir le transfert, dans une couche 150 imprimable, de motifs 120 préalablement formés à la surface du moule.

Comme montré sur la **figure 1a** un moule **100** selon l'invention comprend un ou une pluralité de membranes flexibles **110** présentant chacune une face avant 111 et une face arrière 112. La face avant 111 porte des motifs **120,** par exemple en relief, qui sont destinés à être reproduits par impression dans la couche 150 imprimable. Cette couche 150 imprimable est typiquement une couche de résine.

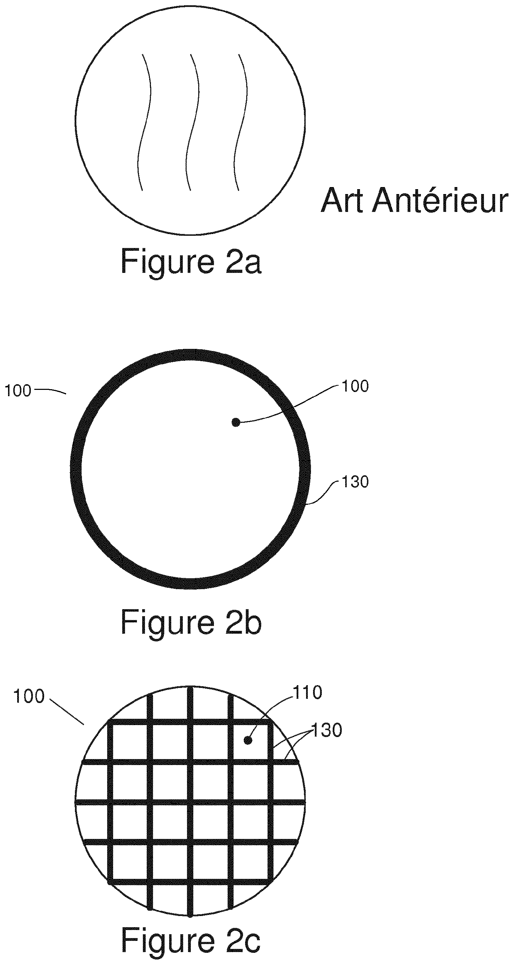

Le mode de réalisation illustré en figure 1 ne fait apparaître qu'une seule membrane 110. Dans d'autres modes de réalisation décrits en détail par la suite en référence aux figures 2c, 7, 8 et 9 le moule 100 comprend plusieurs membranes 110.

Les membranes 110 flexibles sont réalisées de manière à être solidaires des zones non déformables qui les entourent, lesquelles constituent un cadre rigide 130. Ainsi le cadre rigide 130 est configuré pour maintenir mécaniquement la membrane 110. Par ailleurs, il confère au moule 100 les propriétés mécaniques indispensables pour obtenir une bonne impression des motifs 120. Le plus généralement un moule 100 selon l'invention est réalisé dans un substrat également désigné tranche ou wafer d'un type couramment utilisé par l'industrie de la micro-électronique et notamment à partir d'un substrat en silicium (Si), matériau semi-conducteur le plus courant qui possède aussi d'excellentes propriétés mécaniques.

Le cadre rigide 130 forme ainsi avec la membrane 110 une cavité 115. Le cadre forme les parois 132 latérales de la cavité 115 et la face arrière 112 de la membrane 110 forme le fond de la cavité 115.

La formation des motifs 120, de la cavité 115, de la membrane 110 sera décrite par la suite.

La **figure 1b** illustre la déformation que la ou les membranes flexibles **110** recouvertes des motifs **120** peuvent subir sans inconvénient quand on les met sous pression **140,** par exemple, en introduisant un gaz dans les cavités **115.** De préférence le gaz est de l'air sans que cela soit limitatif.

Ainsi lorsqu'on met sous pression la cavité 115, la membrane 110 flexible se déforme en s'éloignant du cadre rigide 130. Les motifs 120 portés par la membrane 110 se déplacent ainsi dans un premier sens appelé sens d'impression.

Les **figures 1c à 1e** illustrent comment un moule selon l'invention est alors utilisé pour transférer les motifs **120** formés à la surface du moule 100 dans une couche de résine et plus généralement dans une couche imprimable **150** qui a elle-même été déposée à la surface d'un substrat **160.** Par exemple le substrat 160 peut porter des dispositifs micro-électroniques comme des circuits intégrés ou hybrides, incluant par exemple des composants optiques et/ou mécaniques, en cours de fabrication.

Comme montré sur la figure 1c, le moule **100** étant amené à proximité de la surface **151** de la couche 150 à imprimer, on utilise la flexibilité de la membrane **110** pour réaliser l'impression des motifs 120 dans la couche **150** à l'aide d'une mise sous pression **140** de cette dernière. Les motifs 120 se déplacent dans le sens d'impression jusqu'à pénétrer dans la couche imprimable 150. La zone supportant les motifs 120 à imprimer étant flexible l'impression est plus homogène et le contact quasi conforme entre le moule 100 et la couche 150 imprimable. Ceci se traduit par l'obtention d'une épaisseur résiduelle **152** homogène sur toute la surface d'impression. De plus, la flexibilité de la membrane 110 permet de limiter l'impact des poussières et/ou des défauts. Les risques d'endommagement du moule 100 selon l'invention sont donc réduits par rapport aux moules rigides.

Selon un mode de réalisation non limitatif, la membrane **110** est suffisamment fine pour être assez transparente pour pouvoir y inclure des marques d'alignement (non représentées) qui peuvent servir à positionner les motifs 120 du moule 100 sur des marques d'alignement ou motifs préalablement réalisés sous ou sur la couche 150 à imprimer.

Comme illustré sur la figure 1d, une mise en dépression **170** des cavités 115 sous les membranes 110 flexibles entraîne un retour de la membrane 110. Ce retour est rendu possible par l'élasticité de la membrane 110. Les motifs 120 se déplacent ainsi dans un deuxième sens, opposé au premier, et désigné sens de démoulage. Les motifs 120 se retirent alors de la couche imprimable 150, réalisant ainsi un démoulage **180** qui se fait d'une façon similaire à un pelage comme avec un moule souple. On obtient donc un moule qui intègre par construction les moyens pour réaliser les opérations de moulage et de démoulage.

La figure 1e illustre le résultat final où le moule **100**, après séparation, a retrouvé sa forme initiale. Les motifs 120 du moule ont été reproduits en creux **122** dans la couche **150** laissant en place une couche résiduelle **152** homogène sur toute la surface imprimée.

La **figure 2** composée des figures 2a à 2c compare un moule selon l'état de la technique avec différents types de moules selon l'invention.

La figure 2a illustre un moule 100 intégralement souple selon l'art antérieur. Le moule ne comprend pas de cadre rigide.

La figure 2b illustre un moule 100 selon l'invention, comme celui des figures 1a à 1e, comprenant une seule membrane 110 et une seule cavité 115. La membrane 110 est solidaire sur tout son pourtour d'un cadre 130. Le cadre rigide forme par exemple un anneau en périphérie du substrat. Les avantages de ce type de moule 100 ont été mentionnés en référence aux figures 1a à 1e.

La **figure 2c** montre une vue en plan d'un moule **100** selon l'invention dans lequel le cadre rigide 130 forme une grille 130 définissant une pluralité de cavités 115, chacune associée à une membrane 110. Ainsi le moule 100 présente une pluralité de membranes flexibles **110**, chacune complètement incluse dans le cadre rigide **130** formant la grille.

La grille illustrée en figure 2c forme des motifs carrés. Cela n'est évidemment pas limitatif et d'autres motifs de grille peuvent être envisagés dans le cadre de l'invention. On pourra par exemple avoir un cadre 130 rigide définissant une pluralité de cavités 115 circulaires. Ainsi la membrane 110 de chacune de ces cavités 115 présente un pourtour circulaire. Cela permet d'uniformiser les contraintes au niveau du pourtour de solidarisation de la membrane sur le cadre rigide 130.

L'utilisation d'une grille rigide permet de limiter les déformations de nappe qui se produisent inévitablement, avec un moule souple tel que représenté par exemple sur la **figure 2a,** pendant la phase d'alignement et de pressage.

Par rapport à un cadre rigide limitée à la périphérie extérieure d'un moule souple comme montré sur la **figure 2b,** le mode de réalisation de la figure 2c apporte des améliorations significatives. Dans ce dernier cas, la surface totale du moule 100 est divisée en surfaces flexibles plus petites délimitées par le cadre rigide **130** formant grille. Typiquement, on va alors faire correspondre chaque surface flexible à une puce ou « die » implémentant un dispositif complet, par exemple un circuit intégré. On peut alors réaliser simultanément à la surface d'un même substrat ou wafer et au cours d'une même série d'étapes de fabrication une pluralité de dispositifs sous la forme d'une matrice de puces comme représentée sur cette figure 2c.

La présence de la grille rigide **130** permet d'obtenir une meilleure précision d'alignement à l'échelle du substrat. Seules des déformations locales, c'est-à-dire à l'échelle d'une puce, d'amplitudes moins importantes, restent susceptibles de se produire. En effet, comme les différentes zones à imprimer, c'est-à-dire celles correspondant aux zones souples du moule, sont devenues indépendantes les unes des autres les erreurs d'alignement et de déformation sont alors plus homogènes d'une puce à l'autre au contraire des procédés utilisant un moule souple où les erreurs peuvent se propager de proche en proche sur toute la surface à imprimer et où l'homogénéité obtenue à l'échelle du substrat est alors bien moindre.

La réalisation d'un moule selon l'invention se fait avantageusement, comme déjà mentionné, en utilisant du silicium monocristallin matériau semi-conducteur le plus largement utilisé par toute l'industrie de la micro-électronique et qui possède également d'excellentes propriétés mécaniques, ce qui est avantageux pour la réalisation des membranes flexibles. Ce matériau est robuste et résiste bien aux contraintes chimiques et physiques subies pendant les opérations de moulage et de démoulage. Le silicium monocristallin est également peu coûteux en raison du large usage qui en est fait. La réalisation de moules selon l'invention n'est cependant pas limitée à l'utilisation de silicium monocristallin. Par exemple et sans que cela soit limitatif, l'emploi de silicium amorphe ou polycristallin est possible pour peu que ces matériaux offrent des propriétés mécaniques, chimiques et optiques qui soient équivalentes et susceptibles de convenir aux opérations de moulage et de démoulage décrites précédemment. D'autres matériaux tels que le nitrure de silicium Si3N4 ou la silice SiO2 conviennent également pour la réalisation de moules selon l'invention.

Comme cela a déjà aussi été mentionné plus haut, il est avantageux de pouvoir assurer la transparence des membranes 110 afin que les opérations d'alignement d'un moule 100 selon l'invention sur des marques d'alignement ou motifs possiblement déjà réalisés à la surface d'un substrat soient possibles. Pour permettre l'alignement optique au travers du moule 100 il convient tout d'abord que le matériau constituant les membranes 110 flexibles soit utilisable dans une épaisseur suffisamment faible pour qu'elles puissent transmettre la lumière visible, c'est-à-dire celle comprise dans une gamme de longueurs d'ondes ($\lambda$) allant de 400 à 750 nm. L'homme de l'art sait déterminer la transmittance optique (I) d'un solide à partir de la loi de Beer-Lambert qui s'exprime comme suit :

$$I = I_0.\exp(-4\pi.k.z /\lambda)$$

où :

- $I_0$ est l'intensité lumineuse incidente ;
- k est le coefficient d'atténuation (il dépend de $\lambda$) ;
- z est l'épaisseur du film solide traversé par la lumière ;

À est la longueur d'onde.

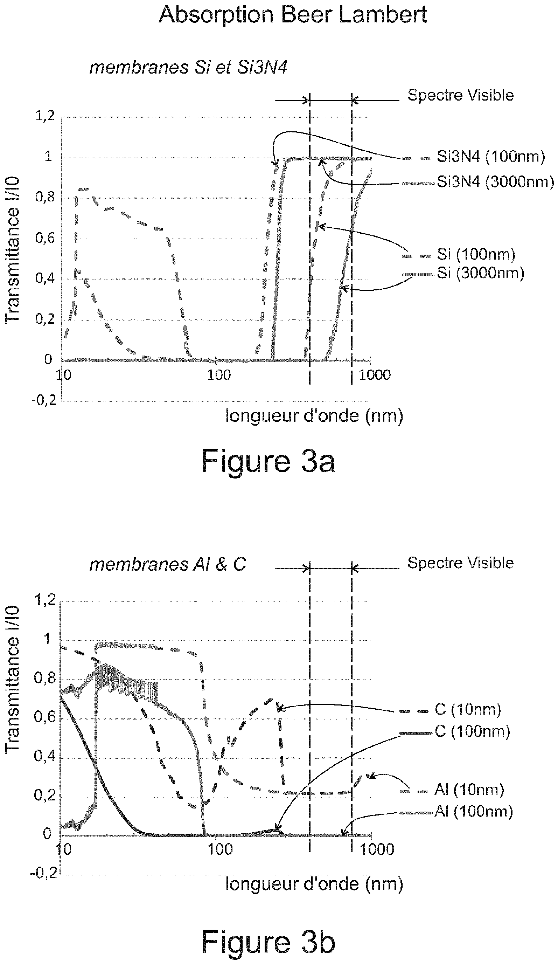

À titre d'exemple la **figure 3** montre la transmission de lumière de membranes « transparentes » dans le spectre des longueurs d'ondes visibles (400 nm < $\lambda$ < 750nm), en silicium ou nitrure de silicium sur la **figure 3a** et, pour comparaison, sur la **figure 3b,** de membranes « non transparentes » qui seraient faites en aluminium ou carbone. Il apparait en figure 3a que le $Si_3N_4$ est un bon candidat pour une large gamme d'épaisseurs tandis qu'une membrane en Si doit nécessairement être très fine pour être suffisamment transparente.

Pour les matériaux « transparents » tels que le silicium on observe que l'on garde au moins 40% de transmission de lumière (dans le rouge) pour une épaisseur de 3 micromètres. Ce qui est suffisant pour faire de l'alignement optique. Pour des matériaux « non transparents » tels que l'aluminium, il faudrait réduire l'épaisseur de la membrane à 10 nm pour n'obtenir seulement que 20% de lumière transmise dans le spectre des longueurs d'ondes visibles.

Par ailleurs, une bonne mise en oeuvre de l'invention demande aussi la prise en compte d'un paramètre supplémentaire qui est la déformation mécanique de la membrane **110** mince transparente qui supporte les motifs **120** à imprimer comme montré sur la figure 1 et aussi des marques d'alignement optique (non représentés). Avant toute application d'une pression **140** de moulage la membrane **110** doit déjà avoir la meilleure planéité possible afin de permettre un alignement optique optimal du moule sur les motifs déjà possiblement réalisés aux étapes précédentes. La précision de l'alignement dépend de la résolution ultime des motifs **120** à imprimer et des règles de dessin. En tenant compte de l'état de l'art des équipements de lithographie actuels on considère que l'alignement doit être réalisé avec une précision de 5 nm. En conséquence, il faut pouvoir fabriquer une membrane **110** dont la déformation sous l'effet de son propre poids, et par conséquent son allongement, n'excède pas cette valeur.

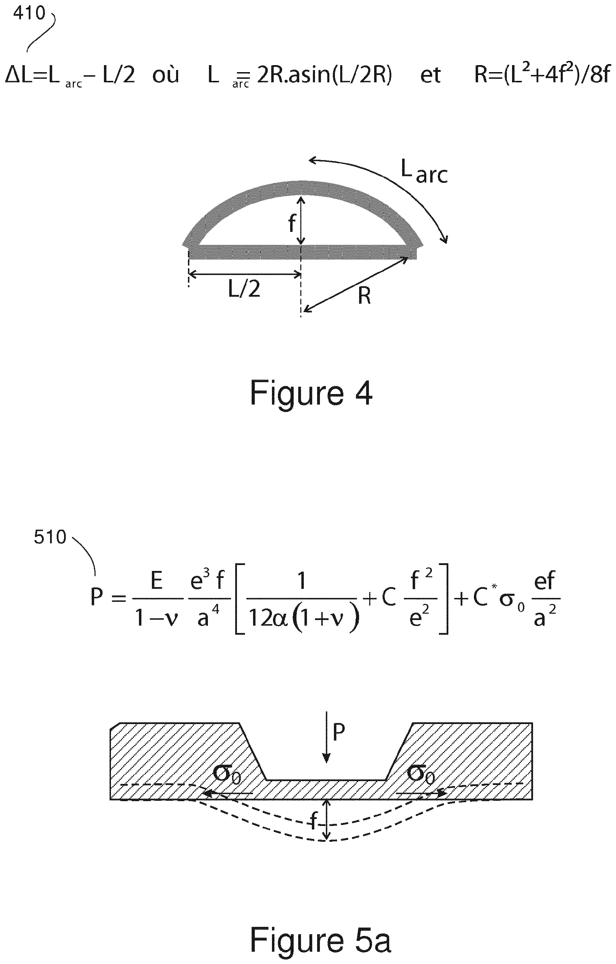

Pour une membrane de forme carrée de 25 mm ($10^{-3}$ mètre) de côté et d'une épaisseur de 1 $\mu$m ($10^{-6}$ mètre) on observe dans ces conditions, du fait du seul poids de la membrane, une flèche maximale de 11,7 $\mu$m et un allongement de la membrane de 26,7 nm dans l'hypothèse d'une déformation sphérique conformément au modèle et aux équations figurant sur la **figure 4.** Pour ne pas dépasser la valeur maximale de 5 nm il faut donc fabriquer la membrane selon un procédé qui la tende mécaniquement afin de ramener son allongement au repos à cette valeur.

On remarquera ici que l'omission du poids de la membrane dans les calculs de conceptualisation et de dimensionnement de celle-ci conduit à réaliser des membranes présentant une flèche sans qu'elles soient pour autant soumises à une sollicitation extérieure autre que la gravité. En effet, dans le cas où l'épaisseur de la membrane est très faible au regard de sa surface, sa rigidité n'est plus alors suffisante pour contrecarrer l'effet de son propre poids qui n'est plus négligeable. Il y a alors déformation de la membrane sous la forme d'une flèche. La déformation de la membrane est toujours orientée vers le sol, elle change de sens lorsque l'on retourne la membrane. Cette considération est contre-intuitive dans les micro et nanotechnologies où l'influence du poids des structures est généralement considérée comme négligeable, seules les contraintes résiduelles, thermiques ou mécaniques étant prises en compte pour prévoir les déformations des membranes et donc leur dimensionnement.

On remarquera également que dans la majorité des cas on peut par contre considérer que le poids des motifs eux-mêmes peut être négligé. En effet, si la membrane a par exemple une épaisseur de 1 $\mu$m et jusqu'à 3 $\mu$m pour les grandes surfaces, les motifs auront au plus quelques centaines de nanomètres d'épaisseur. Leur surface couvrant typiquement moins de 50% de la surface de la membrane elle-même leur poids global représentera au plus 20% du poids de la membrane, même pour un matériau deux fois plus dense que le silicium.

Des procédés pour obtenir des films de silicium contraints en tension sont connus de l'homme du métier. On pourra se référer notamment aux documents suivants : la demande de brevet américaine US2012100719 ainsi que la demande de brevet française correspondante portant la référence FR2947096. On pourra aussi se référer à la publication intitulée « Fabrication of buckling free ultrathin silicon membranes by direct bonding with thermal difference » dont les auteurs sont : Florian Delachat, Christophe Constancias, Frank Fournel, Christophe Morales, Boris Le Drogoff, Mohamed Chaker et Joëlle Margot, publiée dans « ACS Nano » en avril 2015.

L'état de l'art dans ce domaine permet de produire des films de silicium contraints en tension jusqu'à des valeurs de quelques dizaines de méga-pascals (MPa) en particulier en utilisant une technique dite de collage moléculaire direct.

De manière générale, une membrane pour un moule selon l'invention, en référence à la figure 1, peut être obtenue de la manière suivante :

- Fourniture d'un empilement de couches comprenant une première couche de support destinée à former le cadre rigide 130 et une deuxième couche destinée à former la ou les membranes 110 ; une face arrière 112 de la deuxième couche étant tournée au regard d'une face avant de la première couche, par exemple en contact direct ; la deuxième couche est formée de manière à présenter une contrainte en tension.
- Formation des motifs 120 sur la deuxième couche ;
- Libération d'une ou des membranes 110 par gravure d'une zone seulement de la première couche depuis la face arrière de la première couche avec arrêt de la gravure sur ou dans la deuxième couche de manière à former une cavité 115 présentant des parois 132 latérales formées par la première couche et un fond formé par la deuxième couche.

De préférence l'étape de formation des motifs **120** sur la deuxième couche est effectuée avant l'étape de libération d'une ou des membranes **110**. Cela permet de faciliter la définition de motifs précis puisque la deuxième couche présente une résistance suffisante.

Selon un autre mode de réalisation, l'étape de formation des motifs 120 sur la deuxième couche est effectuée après l'étape de libération d'une ou des membranes **110**.

On pourra par exemple réaliser les motifs **120** par photolithographie, par lithographie par faisceau d'électrons (ebeam) ou par lithographie extrême ultraviolet (eUV).

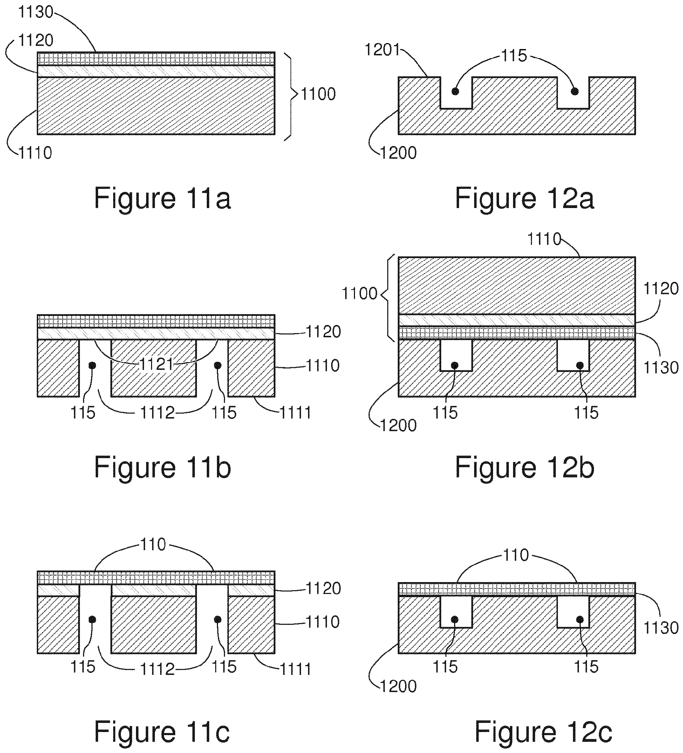

Avantageusement, comme illustrée sur la **figure 11,** composée des figures 11a à 11c, on utilise pour réaliser la membrane un substrat dit SOI **1100,** acronyme de l'anglais « silicon on insulator », formé, comme représenté sur la figure 11a, d'un substrat support **1110** en général fait de silicium, d'une couche d'oxyde **1120,** typiquement d'oxyde de silicium et d'une couche superficielle par exemple de silicium **1130.** Comme illustré sur les figures 11b et 11c, la libération des membranes est obtenue dans un premier temps par lithographie et gravure du substrat support **1110** à partir de sa face arrière **1111** en se servant de préférence de la couche d'oxyde **1120** comme couche d'arrêt de gravure. Les parties de la couche d'oxyde révélées au niveau des ouvertures 1112 ainsi réalisées 1121 sont ensuite éliminées par gravure sélective vis-à-vis de la couche superficielle de silicium 1130. La couche de silicium située dans le fond des ouvertures 1112 forme ainsi une membrane. La gravure sélective de la couche d'oxyde 1121 libère ainsi les membranes de silicium 110. Les parois de la couche du substrat support **1110** et de la couche d'oxyde 1120 forment ainsi le cadre et définissent avec les membranes de silicium 110 les cavités 115 en regard de la face interne de la membrane.

L'utilisation de gravures sélectives permet d'obtenir des membranes d'épaisseur contrôlée et uniforme sur toute la surface du moule.

Comme illustré sur la **figure 12,** composée des figures 12a à 12c dans une autre variante de mise en oeuvre d'un moule selon l'invention, on réalise d'abord les cavités **115** depuis la face avant **1201** d'un substrat homogène **1200** entièrement fait par exemple de silicium. Ceci est illustré par la figure 12a. Comme illustré sur la figure 12b, ce substrat est ensuite assemblé par cette face avant **1201** à un substrat SOI **1100** au niveau de son film mince **1130** par exemple de silicium. Ce collage est par exemple effectué par collage direct hydrophobe. Ce collage peut être renforcé par un traitement thermique à haute température.

Après une étape de retrait du substrat support **1110** du SOI par exemple par rectification mécanique et gravure chimique suivie d'une étape de retrait de l'oxyde **1120** par exemple par gravure chimique de l'oxyde **1120** on obtient des membranes **110** en silicium recouvrant une grille de silicium. Les motifs peuvent alors être réalisés à la surface de la membrane, par lithographie et gravure ou par collage de motifs sur cette face.

Plus généralement, on pourra dans cet exemple utiliser à la place du SOI, une couche mince reportée ou déposée sur un substrat support, la couche mince étant destinée à former la future membrane. On vient coller cette structure sur un substratoù l'on a préalablement réalisé les cavités **115**, au niveau de son interface de collage, puis on élimine le substrat support par exemple par rectification et gravure sélective.

Comme illustré sur la **figure 4** et dans l'expression ci-dessous, en faisant l'hypothèse d'une déformation sphérique d'une membrane 110 carrée, on peut considérer l'allongement $\Delta L$ de la membrane comme étant la différence de longueur entre l'arc $L_{arc}$ de la déformée sphérique et la longueur L de la membrane plane :

$$\Delta L = L_{arc} - L/2 \quad \text{où} \quad L_{arc} = 2R.\text{asin}(L/2R) \quad \text{et} \quad R = (L^2+4f^2)/8f \ ,$$

Dans cette expression, L est la longueur de la membrane carrée plane, $L_{arc}$ la longueur d'arc de la membrane déformée sphérique, R le rayon de déformée sphérique et f la flèche ou déformée maximale au centre de la membrane. On détermine ainsi l'allongement **410** ($\Delta L$) de la membrane et on peut en déduire la contrainte en tension qu'il est nécessaire d'appliquer à la membrane pour ramener $\Delta L$ à une valeur qui soit inférieure ou égale à 5 nm. Pour se faire l'homme du métier peut avoir recours à de la simulation numérique, par exemple, avec un logiciel de calcul par éléments finis tel que celui distribué commercialement par la société ANSYS France sise à Montigny-le-Bretonneux.

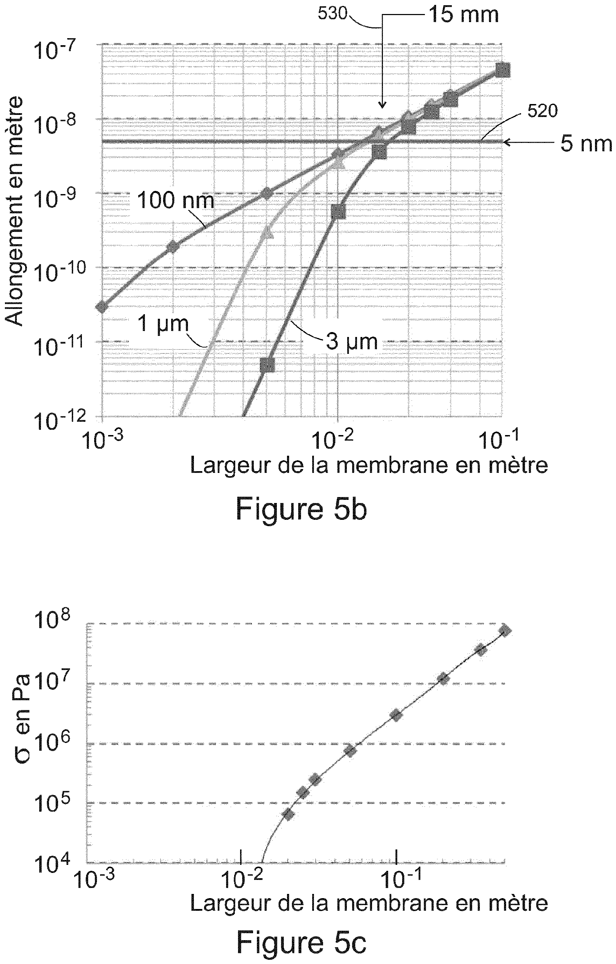

Comme illustré sur la **figure 5,** composée des figures 5a à 5c, on peut aussi appliquer, comme montré sur la **figure 5a**, une formule analytique **510** issue de la théorie connue dite « des plaques et des coques » donnant une expression qui associe la flèche f (déformée maximale) d'une membrane à la contrainte résiduelle $\sigma_0$ dans la membrane et à la pression P qui s'exerce sur celle-ci. On y distingue trois termes tenant compte : des petites déformations en *f* linéaire ; des grandes déformations en f cubique et de l'état de précontrainte $\sigma_0$. Les facteurs apparaissant dans cette formule sont : E module d'Young ; v coefficient de Poisson de la membrane ; a et b respectivement la largeur et la longueur de la membrane ; e épaisseur de la membrane ; les valeurs *C*, *C** et $\alpha$ dépendent de *b*/*a,* e et de v. Par exemple, pour une membrane carrée où a = b, on a :

$$a = 1{,}26 \cdot 10^{-3}\ ;\ C|_{a=b} = C.C_m\ ;\ C^* = 13{,}63,\ C = 21{,}75$$

et

$$C_m=(C_0-C_1n)-(C_2-C_3n)\exp[-C_4h/e]+(C_5-C_6e)\exp[-C_7h/e].$$

La table des coefficients $C_i$ pour a=b est :

| $C_0$ | $C_1$ | $C_2$ | $C_3$ | $C_4$ | $C_5$ | $C_6$ | $C_7$ |
|---|---|---|---|---|---|---|---|
| 1,41 | 0,292 | 1,64 | 1,466 | 1,4 | 0,173 | 0,00235 | 0,1 |

Comme montré sur la **figure 5b,** partant de ces définitions, on peut alors calculer, en fonction de sa dimension, l'allongement d'une membrane carrée soumise à son propre poids. Lorsque l'allongement dépasse la valeur critique qui a été estimée précédemment à 5 nm, on calcule la contrainte en tension qu'il faut lui appliquer, en fonction de sa dimension, pour ramener l'allongement qu'elle subit à la valeur critique à ne pas dépasser.

La figure 5b fait apparaître que l'allongement d'une membrane sous son propre poids dépasse toujours 5 nm **520** dès que sa largeur est supérieure à 15 mm **530** pour des épaisseurs utiles à l'invention, c'est-à-dire pour une épaisseur inférieure ou égale à 3 $\mu$m afin de conserver une transparence suffisante qui va permettre de procéder à l'alignement optique du moule **100** relativement au substrat **160** portant la couche imprimable **150.**

Dans le domaine des masques optiques de lithographie, la dimension typique des champs sur masque optique standard pouvant atteindre 30 mm de côté, il est donc nécessaire de produire des membranes **110** de cette dimension, précontraintes en tension pour limiter leur allongement sous leur propre poids lors de l'alignement. Les procédés de fabrication de membranes en silicium tendues par la méthode de collage moléculaire mentionnée précédemment peuvent nécessiter d'avoir à appliquer une tension de quelques centaines de méga-pascals. La **figure 5c** montre en abscisse les valeurs de tension qu'il faut appliquer à une membrane carrée, en fonction de sa largeur, pour réduire sa déformation sous son propre poids à un allongement ne dépassant pas 5 nm.

Selon un mode de réalisation la relation générale entre le fléchissement f et la surface de la membrane est donnée par cette expression où $a^2$ correspond à la surface pour une membrane carrée de largeur a :

$$P=\frac{E}{1-\nu}\frac{e^3 f}{a^4}\left[\frac{1}{12\alpha(1+\nu)}+C\frac{f^2}{e^2}\right]+C^*\sigma_0\frac{ef}{a^2}$$

où P est la pression appliquée sur la membrane (ici P=0), E et v respectivement le module d'élasticité et le coefficient de Poisson du matériau constitutif de la membrane, e l'épaisseur de la membrane, C, C* et $\alpha$ des constantes géométriques et $\sigma_0$ la contrainte appliquée à la membrane. On peut grâce à cette formule déterminer le dimensionnement de la membrane. Ce qu'il faut c'est que l'allongement de la membrane sous son propre poids (à l'exclusion d'une pression extérieure) soit inférieur à la tolérance de l'alignement recherché qui est par exemple de l'ordre de 5nm. Si cela n'est pas respecté, il faut redimensionner la membrane ou la tendre (en utilisant par exemple un matériau contraint) pour que ce critère soit respecté.

Au vu des formules des figures 4 et 5 et des explications ci-dessus, on comprend aisément que pour obtenir la tolérance d'alignement recherchée, on peut également jouer que les dimensions de la membrane 110 pour que son allongement sous pression soit inférieur à cette tolérance.

Comme on l'a vu avec la description de la figure 1, et plus particulièrement sur la figure 1c, le transfert des motifs **120** disposés sur la membrane **110** est réalisé par l'application d'une pression **140** du côté opposé de la membrane flexible. Avant la mise en pression, le moule **100** comprenant typiquement une pluralité de membranes **110**, est amené à proximité du substrat sur lequel a été déposé une couche de résine **150** de façon à le recouvrir complètement. La distance **102** entre moule et résine peut être optionnellement contrôlée par une butée **104**, également désignée cale. Cette butée **104** est placée côté motifs **120** c'est-à-dire que la butée s'étend depuis le cadre rigide **130** ou depuis la membrane **110** et au-delà de la face avant **111** de la membrane **110**. La butée **104** garantit que le moule **100** et le substrat **160** sont bien parallèles sur toute leur étendue et qu'on obtient ainsi une distance uniforme entre les motifs **120** et la résine de la couche imprimable **150** avant l'opération d'impression.

De préférence, le ou les butées 104 sont formées sur la face avant **111** de la membrane **110** avant que cette dernière ne soit libérée. Ainsi, on peut d'abord réaliser les butées **104** sur une face avant de la couche formant la membrane ou d'une couche recouvrant la membrane **110** puis, ensuite, libérer la face arrière **131** du substrat pour former le cadre rigide **130** et la ou les cavités **115**.

Selon une autre mode de réalisation, on libère en premier lieu la ou les membranes **110** puis ensuite, on forme la ou les butées **104** sur la face avant de la couche formant la membrane **110** ou sur la face avant d'une couche recouvrant la membrane **110**.

De préférence, on utilisera la lithographie optique pour réaliser les butées **104** car les dimensions sont plus importantes. On pourra par exemple réaliser les butées **104** par photolithographie, par lithographie par faisceau d'électrons (ebeam) ou par lithographie extrême ultraviolet (eUV). Les butées peuvent également être des pièces rapportées et collées sur la face avant des membranes dans l'alignement du cadre rigide **130**, par exemple une fois que toutes les étapes de fabrication du moule sont réalisées.

Typiquement, leurs dimensions dans un plan perpendiculaire à celui dans lequel s'étend principalement le cadre rigide **130** sont supérieures au micron puisque la hauteur des butées est comprise entre plusieurs centaines de nanomètres et plusieurs micromètres. Par exemple ces butées **104** pourront avoir une épaisseur de 5 à 50 μm et être intégrées à la surface du moule.

La largeur des butées, c'est-à-dire leur dimension selon une direction parallèle au plan dans lequel le cadre rigide **130** s'étend principalement, est supérieure au plus grand motif **120** porté par le moule **100**.

Concernant les motifs **120 à** imprimer, leurs dimensions vont de préférence de quelques dizaines de nanomètres à quelques micromètres pour la largeur (c'est-à-dire pour des dimensions prises dans un plan parallèle à celui dans lequel le cadre **130** s'étend principalement) et de quelques dizaines de nanomètres à quelques micromètres pour la hauteur (prise selon une direction perpendiculaire au plan dans lequel le cadre **130** s'étend principalement).

La hauteur des butées doit alors être supérieure à la hauteur des motifs additionnée de la valeur potentielle de la déformée de la membrane **110**, c'est-à-dire, normalement quelques nanomètres au plus. Pour s'assurer de s'affranchir de toute interaction de type Van der Waals, c'est-à-dire, interaction longue portée qui pourrait déstabiliser la couche imprimable **150** de résine en l'absence de contact avec le moule **100**, il est avantageux d'imposer une distance minimum entre la surface supérieure de la couche **150** imprimable de résine et l'extrémité des motifs **120** la plus proche de la couche imprimable **150** de résine. Cette distance minimum est avantageusement supérieure à 100 nm. Cela permet de déterminer la hauteur des butées **104** en fonction de la déformée de la membrane et de la hauteur des motifs **120 à** imprimer.

Les butées **104** peuvent présenter des formes variées. Elles peuvent par exemple reproduire la forme de la grille formée par le cadre rigide 130. Ainsi si les membranes **110** sont de forme carrée ou rectangulaire, la butée 104 pourra former un pourtour continu autour de la membrane **110** et présenter elle-même une forme carrée ou rectangulaire. Si les membranes **110** sont de forme circulaire, la butée 104 pourra former un pourtour continu autour de la membrane **110** et présenter une forme circulaire. La butée 104 forme alors un encadrement autour d'une même membrane 110. L'encadrement est de préférence ajouré pour permettre un passage de gaz lors du déplacement de la membrane afin d'équilibrer les pressions et de permettre une bonne extension de la membrane 110.

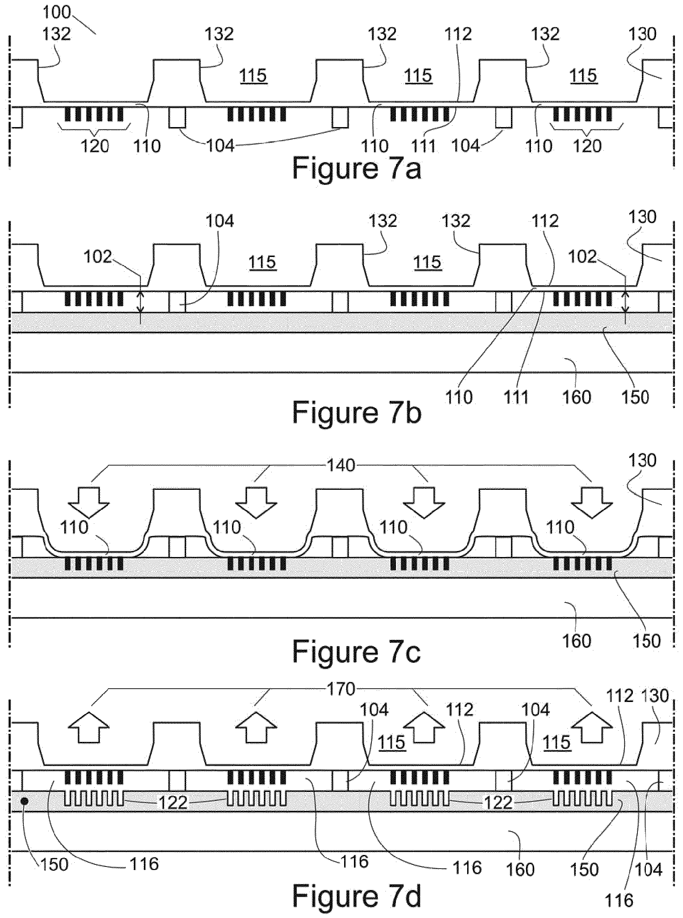

De préférence l'encadrement est conformé pour délimiter, avec la face avant 111 de la membrane 110, une pluralité de cavités 116 avant destinées à être placées en regard de la couche 150 à imprimer. Ces cavités 116 sont référencées en figure 7c.

Les butées **104** peuvent également être ponctuelles. Elles ne forment pas nécessairement un pourtour continu autour de la membrane **110**.

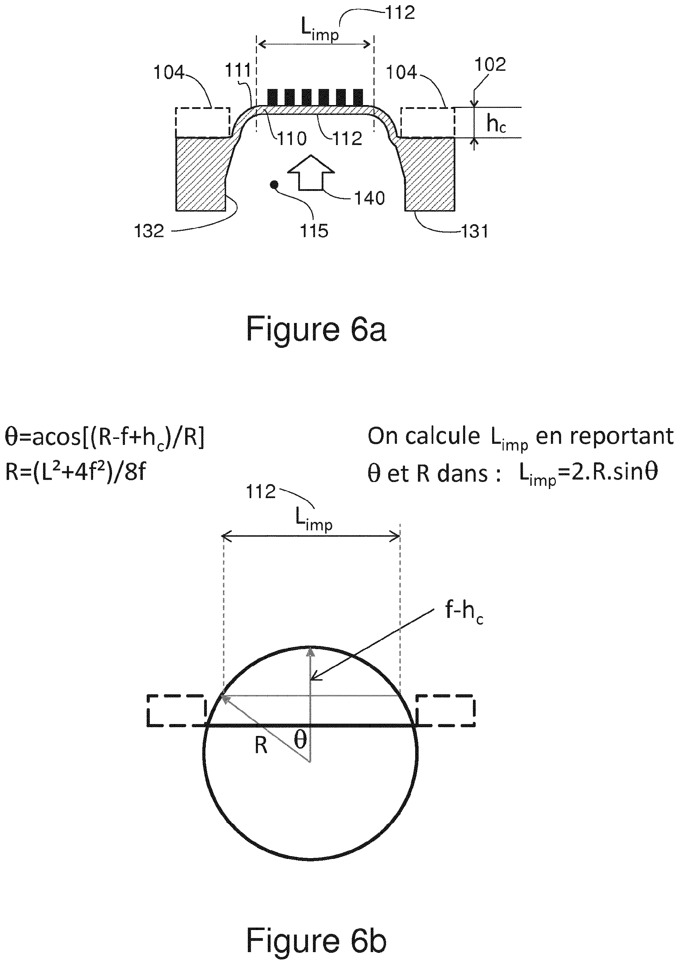

À ce stade de description de l'invention il convient de déterminer la surface d'impression que l'on peut effectivement obtenir à partir d'une membrane flexible telle que **110**. Cette détermination peut se faire à l'aide du modèle illustré par la **figure 6** composée des figures 6a et 6b qui s'applique dans l'hypothèse d'une déformation sphérique d'une membrane mise sous pression.

Après que la contrainte en tension a été déterminée, comme on l'a vu dans la description des figures précédentes (typiquement à une valeur de 15 MPa), dans le but de maintenir la membrane tendue afin que son allongement demeure inférieur à 5 nm, on pourra calculer la largeur d'impression utile. Celle-ci va se faire en fonction de la largeur L de la membrane, de la pression P **140** qu'il faut appliquer pour transférer les motifs dans la résine et de la hauteur **102** de butée (hc) 104 utilisée pour séparer le moule de la résine lorsque le moule est amené à proximité du substrat à imprimer. Le calcul de la largeur effective d'impression $L_{imp}$ **112** se fait en appliquant les formules trigonométriques incluses dans la figure 6 dans l'hypothèse, déjà mentionnée ci-dessus, d'une déformation sphérique de la membrane soumise à une pression en espace libre. On pourra ainsi approximer la longueur d'impression par le calcul de la longueur de corde c = Limp telle que :

$$c = 2\sqrt{(2R - f + hc)(f - hc)}$$

où f est la flèche de la membrane, hc la hauteur de butée 104 et R le rayon de courbure de la membrane. Comme indiqué ci-dessus cette formule montre clairement que la hauteur des butées 104 influence directement les motifs obtenus en fin d'impression.

À titre d'exemple, pour une membrane carrée de 30 mm de côté, d'une épaisseur de 1 $\mu$m et ayant une contrainte de tension de 15 MPa, on obtient, avec une butée 104 de 25 $\mu$m de hauteur, les largeurs d'impression suivantes (Limp en mm) en fonction de la pression appliquée (en millibar) :

| Pression (mbar) : | 0 | 1 | 10 | 100 | 500 | 1000 |
|---|---|---|---|---|---|---|
| Limp (mm) : | | 28,5 | 29,3 | 29,7 | 29,8 | 29,9 |

On observe que la presque totalité de la surface de la membrane 110 peut être transférée dans la résine pour une hauteur de butée 104 de 25 $\mu$m. L'homme du métier pourra ainsi définir une zone périphérique d'exclusion des motifs 120 pour limiter les effets de bords qui induisent toujours des problèmes d'uniformité.

La **figure 7** composée des figures 7a à 7d décrit une variante de l'invention. Dans ce mode de réalisation le cadre rigide 130 définit une pluralité de cavités 115 et de membranes 110 distinctes les unes des autres et portant chacune des motifs 120.

De manière facultative mais avantageuse on réalise, comme montré sur la **figure 7a,** en face avant du moule **100,** c'est-à-dire sur la face où les motifs à imprimer **120** sont présents, les butées **104** mentionnées précédemment et qui permettent, comme on l'a vu, de contrôler parfaitement la distance **102** lorsqu'il faut amener, avant impression, le moule 100 au contact de la couche **150** à imprimer. Cette étape est illustrée par la **figure 7b.**

Les **figures 7c** et **7d** illustrent les étapes suivantes où l'on vient tout d'abord imprimer les motifs **120** dans la résine en mettant sous pression **140** les membranes flexibles, puis en effectuant ensuite le démoulage en les mettant en dépression **170,** étape à l'issue de laquelle on a reproduit les motifs **122** dans la couche de résine **150.**

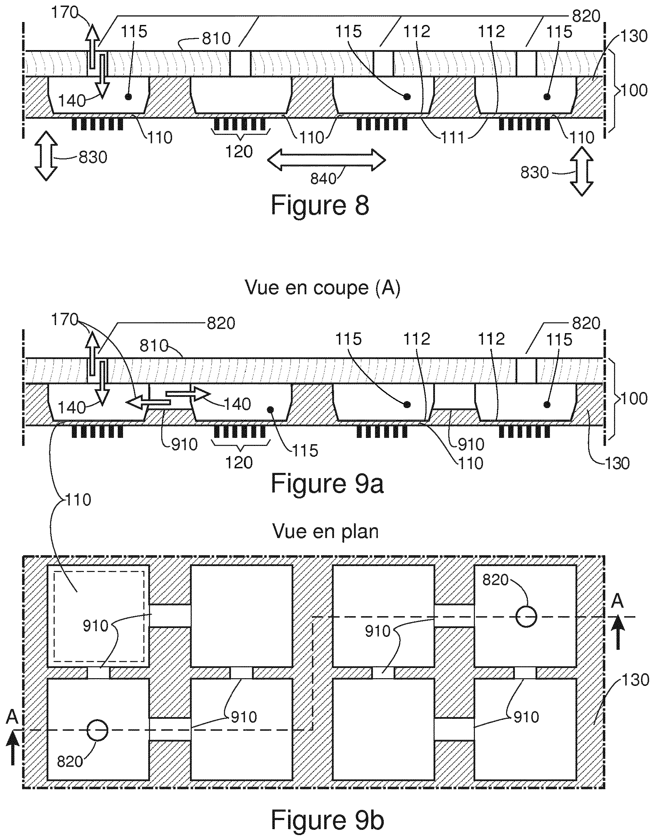

La **figure 8** illustre un mode de réalisation dans lequel le moule 100 comprend un support 810 de préférence rigide et de préférence transparent en face arrière du moule **100.** Il peut s'agir par exemple d'une plaque de verre transparent dans le visible ou d'une plaque de silicium transparent dans l'infrarouge, selon le cas d'intérêt. Ce support 180 maintient le moule 100. Il permet ainsi de contrôler son déplacement vertical 830, c'est-à-dire son déplacement en direction de la couche imprimable 150. Ce support 810 permet également une mise en position et en particulier un ajustement de la distance **102** dans un plan horizontal **840,** afin de réaliser un alignement entre le moule et des motifs ou marques d'alignement déjà réalisés sur le substrat portant la couche 150 de résine ou sur la couche 150 de résine elle-même.

À cette fin, dans cet exemple de mise en oeuvre de l'invention, le support **810** contient en regard de chaque cavité et membrane du moule une ouverture **820** permettant d'injecter un gaz tel que de l'air ou un autre gaz sous pression **140** pour réaliser l'étape d'impression et de pouvoir mettre aussi la cavité en dépression **170** pour réaliser l'étape de démoulage.

La **figure 9** composée des figures 9a et 9b illustre une autre variante d'un moule selon l'invention dans laquelle on pratique moins d'ouvertures **820** dans le support rigide transparent **810** qu'il n'y a de membranes **110** et de cavités **115.** La mise en pression ou dépression de celles-ci se fait alors en ménageant, entre les cavités 115 sous les membranes 110, des canaux de communication **910** reliant plusieurs cavités 115. La **figure 9b** est une vue partielle en plan d'un moule 100 selon l'invention. Ce mode de réalisation permet de réduire le nombre de connexions fluidiques entre le moule 100 et une source de pression. La complexité et le coût du moule 100 en sont ainsi réduits. La **figure 9a** est la vue selon la coupe A de cet exemple de moule.

De manière préférée, le moule est obtenu en réalisant les étapes mentionnées ci-dessus pour obtenir le cadre 130 et la membrane 110 portant les motifs 120 puis en rapportant sur la face arrière 131 du cadre 130 le support 810 par collage direct ou à l'aide d'une colle par exemple.

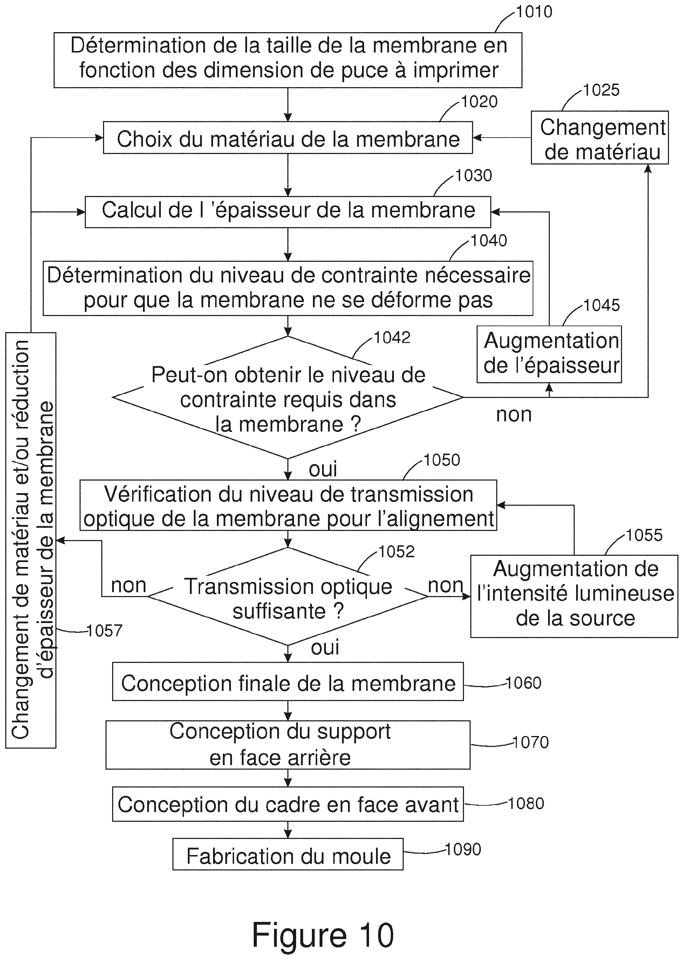

La **figure 10** résume les différentes étapes du procédé de conception et de fabrication d'un moule selon l'invention en fonction de son application.

A l'étape **1010** on détermine tout d'abord la taille que doit effectivement avoir la membrane en fonction de la taille des puces à imprimer et des autres paramètres à considérer comme expliqué avec la description de la figure 6.

On procède ensuite **1020** au choix du matériau qui va constituer la membrane. À ce stade on choisira par exemple le silicium qui est le matériau le plus couramment employé par toute l'industrie de la micro-électronique.

À l'étape suivante **1030** on peut procéder à un premier calcul de l'épaisseur de la membrane comme expliqué avec la description de la figure 3.

Ensuite, il faut déterminer le niveau de contrainte **1040** nécessaire pour que la membrane ne se déforme pas trop initialement sous son propre poids. Ceci est discuté dans la description des figures 4 et 5. Le niveau de déformation acceptable est fixé par l'utilisateur en fonction des performances d'alignement souhaitées pour l'application considérée.

Si la réponse à la question **1042** de savoir si le niveau de contrainte peut effectivement être obtenu avec les paramètres déjà déterminés, est négative, alors il faut envisager une augmentation d'épaisseur **1045** de la membrane et/ou un changement de matériau **1025** et exécuter à nouveau les étapes précédentes.

Si la réponse à la question **1042** est positive alors on peut passer à l'étape suivante où l'on vérifie le niveau de transmission optique des membranes. Si la réponse à la question **1052** de savoir si cette transmission est suffisante pour permettre l'alignement du moule sur des motifs précédemment réalisés, est négative, alors il faut envisager soit une augmentation d'intensité de la source lumineuse **1055** utilisés pour les opérations d'alignement du moule sur un substrat, soit, à nouveau, une réduction d'épaisseur et/ou un changement de matériau **1057** de la membrane.

Si la réponse à la question **1052** est positive alors on peut exécuter les étapes finales suivantes, c'est à dire : à l'étape **1060** on détermine les dimensions de la membrane et on choisit le matériau la constituant ; à l'étape **1070** on détermine les dimensions de la structure qui va constituer la face arrière du cadre ; à l'étape **1080** on fixe les dimensions des butées. Toutes ces dimensions ayant été déterminées on peut, à l'étape **1090**, procéder à la fabrication de ces différentes parties du moule en mettant en oeuvre les procédés associés.

L'invention n'est pas limitée aux modes de réalisations précédemment décrits et s'étend à tous les modes de réalisation couverts par les revendications.

## Revendications

1. Moule (100) de lithographie pour impression nanométrique, comprenant une face avant (111) présentant au moins un motif (120) destiné à être transféré par pressage dans une couche (150) imprimable, ladit moule comprend :

   - au moins une membrane flexible (110) en matériau inorganique formant ladite face avant (111) et portant l'au moins un motif (120), l'au moins une membrane (110) présentant également une face arrière (112) opposée à ladite face avant (111),
   - un cadre (130) solidaire d'une périphérie de l'au moins une membrane (110) et configuré pour former avec ladite face arrière (112) au moins une cavité (115);

   le moule (100) étant configuré de manière à ce qu'une mise sous pression (140) de l'au moins une cavité (115) provoque une déformation de l'au moins une membrane (110) générant un déplacement de l'au moins un motif (120) dans un sens d'impression éloignant l'au moins un motif (120) du cadre (130) **caractérisé en ce que** l'au moins une membrane étant en tension de sorte que son fléchissement f sous l'effet de son propre poids soit inférieure à une tolérance d'alignement prédéterminée de l'au moins un motif (120), la tolérance d'alignement étant inférieure ou égale à 20nm ($10^{-9}$ mètres);

2. Moule (100) selon la revendication précédente dans lequel l'au moins une membrane (110) est, en l'absence de pression dans la cavité, maintenue en tension par le cadre (130) depuis sa périphérie de manière à ce que le fléchissement f de l'au moins une membrane (110) sous son propre poids reste inférieure à ladite tolérance d'alignement des motifs.

3. Moule (100) selon l'une quelconque des revendications précédentes comprenant au moins une butée de positionnement (104) du moule (100) par rapport à la couche (150) imprimable, l'au moins une butée de positionnement (104) s'étendant au-delà de la face avant (111) de l'au moins une membrane (110) flexible, hors d'une zone comprenant l'au moins un motif (120) et sur une hauteur supérieure à la hauteur de l'au moins un motif (120), les hauteurs étant mesurées dans une direction perpendiculaire à un plan dans lequel s'étend principalement le cadre (130), l'au moins une butée de positionnement étant configurée pour prendre appui sur la couche (150) imprimable.

4. Moule (100) selon la revendication précédente, dans lequel l'au moins une butée de positionnement (104) :

   - est située au droit du cadre (130) par rapport à un plan dans lequel s'étend principalement le cadre (130), et/ou
   - est configurée de manière à ce que sa hauteur hc détermine le fléchissement f maximal de l'au moins une membrane (110) lors de la mise sous pression (140) de l'au moins une cavité (115) et lorsque l'au moins une butée de positionnement (104) prend appui sur la couche (150) imprimable, et dans lequel ladite hauteur hc est configurée de sorte que le fléchissement f de l'au moins une membrane (110) lors de la mise sous pression (140) de l'au moins une cavité (115) soit inférieure à ladite tolérance d'alignement des motifs.

5. Moule (100) selon l'une quelconque des revendications 3 à 4, dans lequel l'au moins une butée de positionnement (104) forme un encadrement autour d'une même membrane (110), ledit encadrement étant de préférence ajouré pour permettre un passage de gaz lors du déplacement de la membrane (110).

**6.** Moule (100) selon l'une quelconque des revendications précédentes dans lequel le cadre (130) est conformé pour délimiter, avec la face arrière (112) de l'au moins une membrane (110) une pluralité de cavités (115) et dans lequel la membrane (110) flexible de chaque cavité (115) porte l'ensemble des motifs (120) destinés à l'impression d'une unique puce.

**7.** Moule (100) selon l'une quelconque des revendications précédentes configuré de manière à ce qu'un relâchement de la pression (140) dans l'au moins une cavité (115) ou une mise en dépression (170) de l'au moins une cavité (115) provoque une déformation de la membrane (110) générant un déplacement du motif (120) dans un sens de démoulage les rapprochant du cadre (130).

**8.** Moule (100) selon l'une quelconque des revendications précédentes, dans lequel la solidarisation entre le cadre (130) et la périphérie de la membrane flexible (110) forme un pourtour fermé et continu.

**9.** Moule (100) selon l'une quelconque des revendications précédentes, dans lequel la membrane (110) et le cadre (130) sont formés dans deux couches superposées en contact direct ou indirect.

**10.** Moule (100) selon l'une quelconque des revendications précédentes, dans lequel le cadre (130) comprend une face avant au regard de la face arrière (112) de l'au moins une membrane (110) et une face arrière opposée à sa face avant et dans lequel le moule (100) comprend un support (810) solidaire de sa face arrière et configuré pour fermer la au moins une cavité(115).

**11.** Moule (100) selon l'une quelconque des revendications précédentes, dans lequel le cadre (130) forme une grille conformée pour délimiter une pluralité de cavités (115) et dans lequel le support (810) présente pour chaque cavité (115) au moins une ouverture (820) conformée pour sélectivement autoriser une injection dans ou un retrait hors de la cavité (115) un gaz afin de réguler la pression dans la cavité (115).

**12.** Moule (100) selon l'une quelconque des revendications précédentes, dans lequel le cadre (130) forme une grille conformée pour délimiter une pluralité de cavités (115), dans lequel le cadre (130) comporte des canaux de communication (910) inter cavités (115) conformés pour mettre à la même pression au moins un ensemble de cavités (115) prises parmi ladite pluralité de cavités (115) et dans lequel le support (810) comporte moins une ouverture (820) conformée pour sélectivement injecter dans ou retirer d'au moins une cavité (115) dudit ensemble de cavités (115) un gaz afin de réguler la pression dans la cavité.

**13.** Système comprenant un moule (100) selon l'une quelconque des revendications précédentes et un dispositif d'injection d'un gaz dans ladite cavité (115).

**14.** Procédé de lithographie pour impression nanométrique utilisant un moule (100) selon l'une quelconque des revendications 1 à 12 ou un système selon la revendication précédente, le procédé comprenant les étapes suivantes:

positionner le moule (100) au droit de la couche (150) imprimable ;
mettre sous pression ladite au moins une cavité (115) pour provoquer une déformation de la membrane (110) (110) flexible de manière à générer un déplacement de l'au moins un motif (120) en direction de la couche (150) imprimable et la pénétration de l'au moins un motif (120) dans la couche (150) imprimable jusqu'à une profondeur prédéterminée ;
mettre en dépression ladite cavité (115) ou baisser la pression dans ladite cavité (115) permettre un retour élastique de la membrane (110) flexible de manière à générer un retrait complet de au moins un motif (120) hors de la couche (150) imprimable.

**15.** Procédé de lithographie selon la revendication précédente,

- dans lequel la membrane (110) est transparente et dans lequel les marques ou les motifs d'alignement sont situés au regard de la membrane (110) transparente au moins lorsque l'étape de positionnement est achevée, et/ou
- dans lequel le moule (100) comprend au moins une butée de positionnement (104) dont la hauteur est supérieure à celle de l'au moins un motif (120) et dans lequel le procédé comprend, avant le déplacement de l'au moins un motif (120) en direction de la couche (150) imprimable, une étape de mise en position du moule (100) par rapport à la couche (150) imprimable ou à un substrat solidaire de la couche (150) imprimable, l'étape de mise en position comprenant une étape de rapprochement relatif du moule (100) et de la couche (150) imprimable jusqu'à ce que l'au moins une butée de positionnement (104) entre au contact de la couche (150) imprimable ou du substrat solidaire de la couche (150) imprimable, et/ou
- dans lequel au moins une cavité (115) présente une ouverture (820) ou un canal de communication (910) permettant une communication fluidique directe ou indirecte entre la cavité (115) et une source de pression/dépression, dans lequel la mise sous pression de la cavité (115) comprend l'injection d'un gaz dans la cavité (115) et dans lequel la mise en dépression ladite cavité (115) comprend le retrait du gaz hors de la cavité.

**Patentansprüche**

1. Lithographieform (100) für Nanoimprint, umfassend eine Vorderseite (111), die mindestens ein Muster (120) aufweist, das dazu bestimmt ist, durch Pressen in eine bedruckbare Schicht (150) übertragen zu werden, wobei die Form Folgendes aufweist:

   - mindestens eine flexible Membran (110) aus anorganischem Material, die die Vorderseite (111) bildet und das mindestens eine Muster (120) trägt, wobei die mindestens eine Membran (110) auch eine Rückseite (112) gegenüber der Vorderseite (111) aufweist,
   - einen Rahmen (130), der integral mit einem Umfang der mindestens einen Membran (110) und derart konfiguriert ist, dass er mit der Rückseite (112) mindestens einen Hohlraum (115) bildet;

   wobei die Form (100) derart konfiguriert ist, dass eine Druckbeaufschlagung (140) des mindestens einen Hohlraums (115) eine Verformung der mindestens einen Membran (110) bewirkt, wodurch eine Verschiebung des mindestens einen Musters (120) in einer Druckrichtung erzeugt wird, die das mindestens eine Muster (120) von dem Rahmen (130) wegbewegt,
   **dadurch gekennzeichnet, dass** die mindestens eine Membran derart unter Spannung steht, dass ihre Durchbiegung f ohne Einwirkung ihres eigenen Gewichts kleiner als eine vorbestimmte Ausrichtungstoleranz des mindestens einen Musters (120) ist, wobei die Ausrichtungstoleranz kleiner als oder gleich 20 nm ($10^{-9}$ Meter) ist.

2. Form (100) nach dem vorhergehenden Anspruch, wobei die mindestens eine Membran (110) bei fehlendem Druck im Hohlraum durch den Umfang des Rahmens (130) derart unter Spannung gehalten wird, dass die Durchbiegung f der mindestens einen Membran (110) unter ihrem eigenen Gewicht kleiner als die Musterausrichtungstoleranz bleibt.

3. Form (100) nach einem der vorhergehenden Ansprüche, umfassend mindestens einen Positionierungsanschlag (104) der Form (100) im Verhältnis zu der bedruckbaren Schicht (150), wobei sich der mindestens eine Positionierungsanschlag (104) über die Vorderseite (111) der mindestens einen flexiblen Membran (110) hinaus erstreckt, außerhalb eines Bereichs, der das mindestens eine Muster (120) umfasst, und über einer Höhe, die größer als die Höhe des mindestens einen Musters (120) ist, wobei die Höhen in einer Richtung senkrecht zu einer Ebene gemessen werden, in der sich der Rahmen (130) im Wesentlichen erstreckt, wobei der mindestens eine Positionierungsanschlag derart konfiguriert ist, dass er auf der bedruckbaren Schicht (150) aufliegt.

4. Form (100) nach dem vorhergehenden Anspruch, wobei der mindestens eine Positionierungsanschlag (104):

   - im Verhältnis zu einer Ebene, in der sich der Rahmen (130) im Wesentlichen erstreckt, in einer Linie mit dem Rahmen (130) angeordnet ist, und/oder
   - derart konfiguriert ist, dass seine Höhe hc die maximale Durchbiegung f der mindestens einen Membran (110) während der Druckbeaufschlagung (140) des mindestens einen Hohlraums (115) bestimmt und wenn mindestens ein Positionieranschlag (104) auf der bedruckbaren Schicht (150) aufliegt, und wobei die Höhe hc derart konfiguriert ist, dass die Durchbiegung f der mindestens einen Membran (110) während ihrer Druckbeaufschlagung (140) des mindestens einen Hohlraums (115) kleiner als die Musterausrichtungstoleranz ist.

5. Form (100) nach einem der Ansprüche 3 bis 4, wobei der mindestens eine Positionierungsanschlag (104) eine Umrahmung um dieselbe Membran (110) bildet, wobei der Umrahmung vorzugsweise perforiert ist, um während der Verschiebung der Membran (110) einen Gasdurchtritt zu ermöglichen.

6. Form (100) nach einem der vorhergehenden Ansprüche, wobei der Rahmen (130) ausgebildet ist, um mit der Rückseite (112) der mindestens einen Membran (110) eine Vielzahl von Hohlräumen (115) zu begrenzen, und wobei die flexible Membran (110) jedes Hohlraums (115) alle Muster (120) trägt, die zum Drucken eines einzelnen Chips bestimmt sind.

**7.** Form (100) nach einem der vorhergehenden Ansprüche, die derart konfiguriert ist, dass eine Druckentlastung (140) in dem mindestens einen Hohlraum (115) oder eine Erzeugung von Unterdruck (170) des mindestens einen Hohlraums (115) eine Verformung der Membran (110) bewirkt, wodurch eine Verschiebung des Musters (120) in einer Entformungsrichtung, die sie näher an den Rahmen (130) bringt, erzeugt wird.

**8.** Form (100) nach einem der vorhergehenden Ansprüche, wobei die Verbindung zwischen dem Rahmen (130) und dem Umfang der flexiblen Membran (110) einen festen und durchgehenden Rand bildet.

**9.** Form (100) nach einem der vorhergehenden Ansprüche, wobei die Membran (110) und der Rahmen (130) in zwei übereinander liegenden Schichten in direktem oder indirektem Kontakt ausgebildet sind.

**10.** Form (100) nach einem der vorhergehenden Ansprüche, wobei der Rahmen (130) eine der Rückseite (112) der mindestens einen Membran (110) zugewandte Vorderseite und eine ihrer Vorderseite gegenüberliegende Rückseite umfasst und wobei die Form (100) ein Stützelement (810) umfasst, das an ihrer Rückseite befestigt und derart konfiguriert ist, dass es den mindestens einen Hohlraum (115) schließt.

**11.** Form (100) nach einem der vorhergehenden Ansprüche, wobei der Rahmen (130) ein geformtes Gitter bildet, um eine Vielzahl von Hohlräumen (115) zu begrenzen, und wobei das Stützelement (810) für jeden Hohlraum (115) mindestens eine geformte Öffnung (820) aufweist, um selektiv ein Einblasen eines Gases in den Hohlraum (115) oder ein Entfernen davon zu ermöglichen, um den Druck im Hohlraum (115) zu regulieren.

**12.** Form (100) nach einem der vorhergehenden Ansprüche, wobei der Rahmen (130) ein geformtes Gitter bildet, um eine Vielzahl von Hohlräumen (115) zu begrenzen, wobei der Rahmen (130) Verbindungskanäle (910) zwischen den geformten Hohlräumen (115) aufweist, um mindestens eine Gruppe von Hohlräumen (115) aus der Vielzahl von Hohlräumen (115) mit dem gleichen Druck zu beaufschlagen, und wobei das Stützelement (810) mindestens eine geformte Öffnung (820) umfasst, um ein Gas in mindestens einen Hohlraum (115) der Gruppe von Hohlräumen (115) selektiv einzublasen oder daraus zu entfernen, um den Druck in dem Hohlraum zu regulieren.

**13.** System, umfassend eine Form (100) nach einem der vorhergehenden Ansprüche und eine Vorrichtung zum Einblasen eines Gases in den Hohlraum (115).

**14.** Lithographieverfahren für Nanoimprint unter Verwendung einer Form (100) nach einem der Ansprüche 1 bis 12 oder System nach dem vorhergehenden Anspruch, wobei das Verfahren die folgenden Schritte umfasst:

Positionieren der Form (100) in einer Ebene mit der bedruckbaren Schicht (150);
Druckbeaufschlagen des mindestens einen Hohlraums (115), um eine Verformung der flexiblen Membran (110) (110) zu bewirken, um eine Verschiebung des mindestens einen Musters (120) in Richtung der bedruckbaren Schicht (150) und das Eindringen des mindestens einen Musters (120) in die bedruckbare Schicht (150) bis zu einer vorbestimmten Tiefe zu erzeugen;
Erzeugen eines Unterdrucks in dem Hohlraum (115) oder Senken des Drucks in dem Hohlraum (115) zum Ermöglichen einer elastischen Rückstellung der flexiblen Membran (110), um ein vollständiges Zurückziehen mindestens eines Musters (120) aus der bedruckbaren Schicht (150) zu erzeugen.

**15.** Lithographieverfahren nach dem vorhergehenden Anspruch,

- wobei die Membran (110) transparent ist und die Ausrichtungsmarkierungen oder -muster der transparenten Membran (110) zugewandt angeordnet sind, zumindest wenn der Positionierungsschritt abgeschlossen ist, und/oder
- wobei die Form (100) mindestens einen Positionieranschlag (104) aufweist, dessen Höhe größer ist als die des mindestens einen Musters (120), und wobei das Verfahren vor dem Verschieben des mindestens einen Musters (120) in Richtung der bedruckbaren Schicht (150) einen Schritt des Positionierens der Form (100) im Verhältnis zur bedruckbaren Schicht (150) oder einem Substrat, das integral mit der bedruckbaren Schicht (150) ist, umfasst, wobei der Positionierungsschritt einen Schritt des Annäherns im Verhältnis zu der Form (100) und der bedruckbaren Schicht (150), bis der mindestens einen Positionierungsanschlag (104) mit der bedruckbaren Schicht (150) oder mit dem mit der bedruckbaren Schicht (150) integralen Substrat in Kontakt gelangt, umfasst, und/oder

- wobei mindestens ein Hohlraum (115) eine Öffnung (820) oder einen Verbindungskanal (910) aufweist, der eine direkte oder indirekte Fluidverbindung zwischen dem Hohlraum (115) und einer Druck-/Unterdruckquelle ermöglicht, wobei die Druckbeaufschlagung des Hohlraums (115) das Einblasen eines Gases in den Hohlraum (115) umfasst und wobei die Erzeugung eines Unterdrucks im Hohlraum (115) den Abzug des Gases aus dem Hohlraum umfasst.

## Claims

**1.** A lithography mould (100) for nanoscale printing, comprising a front face (111) having at least one pattern (120) intended to be transferred by pressing into a printable layer (150), said mould comprises:

- at least one flexible membrane (110) made of an inorganic material forming said front face (111) and bearing the at least one pattern (120), the at least one membrane (110) also having a rear face (112) opposite to said front face (111),
- a frame (130) secured to a periphery of the at least one membrane (110) and configured to form with said rear face (112) at least one cavity (115),

the mould (100) being configured so that a pressurisation (140) of the at least one cavity (115) causes a deformation of the at least one membrane (110) generating a movement of the at least one pattern (120) in a printing direction bringing the at least one pattern (120) away from the frame (130),
**characterised in that** the at least one membrane being tensioned so that bending f thereof under the effect of its own weight is lower than a predetermined alignment tolerance of the at least one pattern (120), the alignment tolerance being lower than or equal to 20 nm ($10^{-9}$ metres).

**2.** The mould (100) according to the preceding claim, wherein, in the absence of pressure in the cavity, the at least one membrane (110) is kept tensioned by the frame (130) from its periphery so that the bending f of the at least one membrane (110) under its own weight remains lower than said pattern alignment tolerance.

**3.** The mould (100) according to any one of the preceding claims, comprising at least one stop (104) for positioning the mould (100) with respect to the printable layer (150), the at least one positioning stop (104) extending beyond the front face (111) of the at least one flexible membrane (110), outside an area comprising the at least one pattern (120) and over a height larger than the height of the at least one pattern (120), the heights being measured in a direction perpendicular to a plane in which the frame (130) mainly extends, the at least one positioning stop being configured to bear on the printable layer (150).

**4.** The mould (100) according to the preceding claim, wherein the at least one positioning stop (104):

- is located in line with the frame (130) with respect to a plane in which the frame (130) mainly extends, and/or
- is configured so that its height hc determines the maximum bending f of the at least one membrane (110) during the pressurisation (140) of the at least one cavity (115) and when the at least one positioning stop (104) bears on the printable layer (150), and wherein said height hc is configured so that the bending f of the at least one membrane (110) during the pressurisation (140) of the at least one cavity (115) is lower than said pattern alignment tolerance.

**5.** The mould (100) according to any one of claims 3 to 4, wherein the at least one positioning stop (104) forms a contour around the same membrane (110), said contour preferably being apertured to enable a passage of gas during the movement of the membrane (110).

**6.** The mould (100) according to any one of the preceding claims, wherein the frame (130) is shaped so as to delimit, with the rear face (112) of the at least one membrane (110), a plurality of cavities (115), and
wherein the flexible membrane (110) of each cavity (115) carries all of the patterns (120) intended for the printing of a single chip.

**7.** The mould (100) according to any one of the preceding claims, configured so that a release of the pressure (140) in the at least one cavity (115) or a depression (170) of the at least one cavity (115) causes a deformation of the membrane (110) generating a movement of the pattern (120) in a demoulding direction bringing them closer to the frame (130).

**8.** The mould (100) according to any one of the preceding claims, wherein the connection between the frame (130) and the periphery of the flexible membrane (110) forms a closed and continuous perimeter.

**9.** The mould (100) according to any one of the preceding claims, wherein the membrane (110) and the frame (130) are formed in two superimposed layers in direct or indirect contact.

**10.** The mould (100) according to any one of the preceding claims, wherein the frame (130) comprises a front face opposite the rear face (112) of the at least one membrane (110) and a rear face opposite to its front face and wherein the mould (100) comprises a support (810) secured to its rear face and configured to close the at least one cavity (115).

**11.** The mould (100) according to any one of the preceding claims, wherein the frame (130) forms a grid shaped so as to delimit a plurality of cavities (115) and wherein the support (810) has for each cavity (115) at least one opening (820) shaped so as to selectively enable an injection into or a withdrawal from the cavity (115) of a gas in order to regulate the pressure in the cavity (115).

**12.** The mould (100) according to any one of the preceding claims, wherein the frame (130) forms a grid shaped so as to delimit a plurality of cavities (115), wherein the frame (130) includes inter-cavities (115) communication channels (910) shaped so as to set at the same pressure at least one set of cavities (115) selected from among said plurality of cavities (115) and wherein the support (810) includes at least one opening (820) shaped so as to selectively inject into or withdraw from at least one cavity (115) of said set of cavities (115) a gas in order to regulate the pressure in the cavity.

**13.** A system comprising a mould (100) according to any one of the preceding claims and a device for injecting a gas into said cavity (115).

**14.** A lithography method for nanoscale printing using a mould (100) according to any one of claims 1 to 12 or a system according to the preceding claim, the method comprising the following steps:

position the mould (100) in line with the printable layer (150) ;
pressurise said at least one cavity (115) to cause a deformation of the flexible membrane (110) (110) so as to generate a movement of the at least one pattern (120) in the direction of the printable layer (150) and the penetration of the at least one pattern (120) into the printable layer (150) up to a predetermined depth;
depressurise said cavity (115) or lower the pressure in said cavity (115) to enable an elastic return of the flexible membrane (110) so as to generate a complete withdrawal of at least one pattern (120) out of the printable layer (150).

**15.** A lithography process according to the preceding claim,

- wherein the membrane (110) is transparent and wherein the alignment marks or patterns are located opposite the transparent membrane (110) at least when the positioning step is completed, and/or
- wherein the mould (100) comprises at least one positioning stop (104) whose height is larger than that of the at least one pattern (120) and wherein the method comprises, before the movement of the at least one pattern (120) in the direction of the printable layer (150), a step of positioning the mould (100) with respect to the printable layer (150) or to a substrate secured to the printable layer (150), the positioning step comprising a step of bringing the mould (100) and the printable layer (150) closer to each other until the at least one positioning stop (104) comes into contact with the printable layer (150) or with the substrate secured to the printable layer (150), and/or
- wherein at least one cavity (115) has an opening (820) or a communication channel (910) enabling a direct or indirect fluid communication between the cavity (115) and a pressure/depression source, wherein the pressurisation of the cavity (115) comprises the injection of a gas into the cavity (115) and wherein the depressurisation of said cavity (115) comprises the withdrawal of the gas out of the cavity.

100
111
120
110
112
115
130
132
131
Figure 1a
100
111
120
110
115
112
140
132
131
Figure 1b
102
160
150
151
152
110
104
104
100
140
132
131
115
Figure 1c
180
180
110
170
132
131
115
Figure 1d
152
150
122
110
100
132
131
115
Figure 1e

Art Antérieur

Figure 2a

100
100
130

Figure 2b

100
110
130

Figure 2c

## Absorption Beer Lambert

membranes Si et Si3N4
Spectre Visible
1,2
1
0,8
0,6
0,4
0,2
0
-0,2
Transmitance I/I0
10
100
1000
longueur d'onde (nm)
Si3N4 (100nm)
Si3N4 (3000nm)
Si (100nm)
Si (3000nm)

Figure 3a

membranes Al & C
Spectre Visible
1,2
1
0,8
0,6
0,4
0,2
0
-0,2
Transmitance I/I0
10
100
1000
longueur d'onde (nm)
C (10nm)
C (100nm)
Al (10nm)
Al (100nm)

Figure 3b

410
ΔL=L arc – L/2 où L arc = 2R.asin(L/2R) et R=(L²+4f²)/8f

L arc
f
L/2
R

Figure 4

510

$$P=\frac{E}{1-\nu}\frac{e^{3}f}{a^{4}}\left[\frac{1}{12\alpha(1+\nu)}+C\frac{f^{2}}{e^{2}}\right]+C^{*}\sigma_{0}\frac{ef}{a^{2}}$$

P
σ0
σ0
f

Figure 5a

530
15 mm
520
5 nm
100 nm
1 µm
3 µm
10-7
10-8
10-9
10-10
10-11
10-12
10-3
10-2
10-1
Allongement en mètre
Largeur de la membrane en mètre


Figure 5b

σ en Pa
108
107
106
105
104
10-3
10-2
10-1
Largeur de la membrane en mètre


Figure 5c

112
$L_{imp}$
104
111
104
102
$h_c$
110
112
140
132
115
131

Figure 6a

$\theta$=acos[(R-f+$h_c$)/R]
R=($L^2$+4$f^2$)/8f

On calcule $L_{imp}$ en reportant $\theta$ et R dans : $L_{imp}$=2.R.sin$\theta$

112
$L_{imp}$
f-$h_c$
R
$\theta$

Figure 6b

100
132
132
132
112
132
130
115
115
115
120
110
104
110
111
104
110
120
104
132
132
112
130
102
115
115
102
110
111
160
150
140
130
110
110
110
110
160
150
170
112
130
104
112
104
115
115
122
122
150
116
116
116
160
150
104
116

Figure 7a

Figure 7b

Figure 7c

Figure 7d

170
115
810
115
112
112
115
820
130
140
100
110
120
110
111
110
830
840
830

Figure 8

Vue en coupe (A)
170
820
810
115
112
112
820
115
140
140
100
910
120
115
910
110
130
110
Vue en plan
910
910
820
A
130
910
910
A
820

Figure 9a

Figure 9b

1010
Détermination de la taille de la membrane en fonction des dimension de puce à imprimer
1020
Choix du matériau de la membrane
1025
Changement de matériau
1030
Calcul de l 'épaisseur de la membrane
1040
Détermination du niveau de contrainte nécessaire pour que la membrane ne se déforme pas
1045
Augmentation de l'épaisseur
1042
Peut-on obtenir le niveau de contrainte requis dans la membrane ?
non
oui
1050
Vérification du niveau de transmission optique de la membrane pour l'alignement
1055
Augmentation de l'intensité lumineuse de la source
1052
Transmission optique suffisante ?
non
non
oui
Changement de matériau et/ou réduction d'épaisseur de la membrane
1057
Conception finale de la membrane
1060
Conception du support en face arrière
1070
Conception du cadre en face avant
1080
Fabrication du moule
1090

Figure 10

1130
1120
1100
1110
1201
115
1200
1120
1110
1121
115
1112
115
1111
1110
1100
1120
1130
115
115
1200
110
1120
1110
115
1112
115
1111
110
1130
115
115
1200

Figure 11a

Figure 12a

Figure 11b

Figure 12b

Figure 11c

Figure 12c

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

### Documents brevets cités dans la description


- EP 2483744 A1
- US 2012086149 A1
- US 2012100719 A
- FR 2947096